# EUROPEAN PATENT APPLICATION

(11) **EP 4 375 794 A1**
(43) Date of publication of application: **29.05.2024**
(21) Application number: 23203106.2
(22) Date of filing: 12.10.2023
(51) Int. Cl.: G06F 1/16, G06F 1/20

(54) **FOLDABLE DISPLAY DEVICE INCLUDING SUPPORT AND METHOD OF MANUFACTURING THE SAME**

(30) Priority: 25.11.2022 KR 20220160229
(71) Applicant: Samsung Display Co., Ltd., Yongin-si, Gyeonggi-do 17113 (KR)
(72) Inventor: Cho, Hyunjun, 17113 Yongin-si, Gyeonggi-do, (KR); Nam, Donghun, 17113 Yongin-si, Gyeonggi-do (KR); Lee, Seongjun, 17113 Yongin-si, Gyeonggi-do, (KR)
(74) Representative: Gulde & Partner

(57) **Abstract**

A display device (10) includes a display panel (PNL) including a first non-folding area (NFA1), a second non-folding area (NFA2), and a folding area (FA) disposed between the first non-folding area (NFA1) and the second non-folding area (NFA2). A support (SM) is disposed under the display panel (PNL) and includes a first non-folding portion (NFP1) including glass and overlapping the first non-folding area (NFA1), a second non-folding portion (NFP2) including glass and overlapping the second non-folding area (NFA2), and a folding portion (FP) disposed between the first non-folding portion (NFP1) and the second non-folding portion (NFP2), overlapping the folding area (FA), and including an opening pattern (OPP) or a recess (RCS).

## Description

### TECHNICAL FIELD

The present invention relates to a display device. More specifically, the invention relates to a foldable display device including a support and a method of manufacturing the same.

### DISCUSSION OF THE RELATED ART

Recently, a flexible display device that can be deformed into various shapes has been developed. Unlike a traditional flat panel display, the flexible display device can be folded, bent, or rolled like paper, without cracking or otherwise sustaining damage thereto. The flexible display device is easy to carry and can increase user convenience.

Recently, among flexible display devices, a foldable display device is in the limelight. The foldable display device can be repeatedly folded and unfolded. The foldable display device may include a display module having flexibility and a support structure disposed on a bottom surface of the display module. The support structure has relatively high rigidity, and thus, may serve to prevent deformation of the display module due to a user's touch or the like.

### SUMMARY

A display device includes a display panel including a first non-folding area, a second non-folding area, and a folding area disposed between the first non-folding area and the second non-folding area. A support is disposed under the display panel. The support includes a first non-folding portion including glass and overlapping the first non-folding area, a second non-folding portion including glass and overlapping the second non-folding area, and a folding portion disposed between the first non-folding portion and the second non-folding portion, overlapping the folding area, and including an opening pattern or a recess.

The folding portion may include glass.

The opening pattern may include a plurality of openings, each of which may have a rectangle shape, a rhombus shape, an ellipse shape, a wavy shape, or a rectangle shape with rounded corners.

The display device may further include a filling material filling the opening pattern.

The filling material may be further disposed under the first non-folding portion and the second non-folding portion.

The recess may be an opening or a groove.

The display device may further include a filling material filling the recess.

The filling material may be further disposed under the first non-folding portion and the second non-folding portion.

The display device may further include a support pattern disposed in the recess.

The support pattern may include stainless steel, carbon fiber, and/or fiberglass.

The display device may further include an adhesive layer disposed under the support pattern and may further include a frame disposed under the adhesive layer. The frame may be configured to support the support pattern.

The display device may further include an adhesive layer disposed on the support pattern.

In an embodiment, the adhesive layer may include a pressure sensitive adhesive (PSA), an optically clear resin (OCR), and/or an optically clear adhesive (OCA).

The first non-folding portion may include a first pattern adjacent to the folding portion, and the second non-folding portion may include a second pattern adjacent to the folding portion.

Each of the first pattern and the second pattern may be disposed on one surface of the support and may be spaced apart from the display panel.

A height of each of the first pattern and the second pattern may be smaller than a height of the folding portion, and a width of each of the first pattern and the second pattern may be smaller than a width of the folding portion.

Each of the first pattern and the second pattern may include an opening pattern or a recess.

The display device may further include a black coating layer disposed on one surface of the support and spaced apart from the display panel.

The display device may further include a functional layer disposed under the support and including a black pigment or a black dye.

The display device may further include a digitizer disposed under the support.

The display device may further include a heat dissipation layer disposed under the support.

The heat dissipation layer may include graphite and/or metal.

A method of manufacturing a display device includes forming a carrier substrate including glass. A display panel is formed on the carrier substrate and directly contacts the carrier substrate. The carrier substrate includes a first non-folding area, a second non-folding area, and a folding area disposed between the first non-folding area and the second non-folding area. A support is formed by forming a folding portion having an opening pattern or a recess overlapping the folding area by patterning the carrier substrate.

The forming of the support may further include forming a first non-folding portion overlapping the first non-folding area and may further include forming a second non-folding portion overlapping the second non-folding area by slimming the carrier substrate.

The method may further include forming a first pattern adjacent to the folding portion on the first non-folding portion and may further include forming a second pattern adjacent to the folding portion on the second non-folding portion.

The patterning of the carrier substrate may be performed using an ultraviolet laser.

The forming of the folding portion may include forming the opening pattern or the recess by patterning a portion of the carrier substrate overlapping the folding area.

The method may further include filling the folding portion with a filling material.

The filling material may be applied to the folding portion through an inkjet process, a dispensing process, a molding process, and/or a screen printing process.

The filling material may be further formed under the support.

The method may further include forming a support pattern having an opening pattern disposed on the folding portion.

The support may include stainless steel, carbon fiber, and/or fiberglass.

The method may further include forming a black coating layer containing carbon black on one surface of the support and spaced apart from the display panel.

The carbon black may be applied by a physical vapor deposition (PVD) method or a screen printing method.

The method may further include forming a functional layer including a black pigment or a black dye under the support.

The method may further include forming a digitizer under the support.

The method may further include forming a heat dissipation layer under the support.

The heat dissipation layer may be formed of graphite and/or metal.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

Illustrative embodiments of the present invention will be more clearly understood from the following detailed description taken in conjunction with the accompanying drawings.
FIG. 1 is a perspective view illustrating an unfolded state of a display device according to an embodiment.
FIG. 2 is a cross-sectional view illustrating a folded state of the display device of FIG. 1.
FIG. 3 is a cross-sectional view taken along line I-I' of FIG. 1.
FIG. 4 is a cross-sectional view illustrating a support and a display panel of FIG. 3.
FIG. 5 is an enlarged view of a portion of FIG. 4.
FIG. 6 is a cross-sectional view illustrating a display panel and a support of FIG. 4.
FIGS. 7 to 10 are plan views illustrating a support of FIG. 6.
FIGS. 11 and 12 are cross-sectional views illustrating examples of FIG. 6.
FIG. 13 is a cross-sectional view illustrating an example of FIG. 6.
FIGS. 14 and 15 are cross-sectional views illustrating examples of FIG. 13.
FIG. 16 is a cross-sectional view illustrating an example of FIG. 13.
FIGS. 17 and 18 are cross-sectional views illustrating examples of FIG. 16.
FIG. 19 is a cross-sectional view illustrating an example of FIG. 16.
FIG. 20 is a cross-sectional view illustrating an example of FIG. 19.
FIGS. 21 and 22 are cross-sectional views illustrating examples of FIG. 19.
FIG. 23 is a cross-sectional view illustrating a portion of a display device according to an embodiment.
FIGS. 24 to 26 are cross-sectional views illustrating examples of FIG. 23.
FIG. 27 is a cross-sectional view illustrating a portion of a display device according to an embodiment.
FIGS. 28 and 29 are cross-sectional views illustrating a portion of a display device according to embodiments.
FIG. 30 is a cross-sectional view illustrating a portion of a display device according to an embodiment.
FIG. 31 is a cross-sectional view of a portion of a display device according to an embodiment.
FIG. 32 is a cross-sectional view illustrating an example of Fig. 31.
FIGS. 33 to 38 are views illustrating a manufacturing method of a display device according to an embodiment.
FIGS. 39 and 40 are views illustrating a manufacturing method of a display device according to an embodiment.
FIGS. 41 and 42 are views illustrating examples of FIG. 37.
FIG. 43 is a view illustrating an example of FIG. 42.
FIG. 44 is a view illustrating an example of FIG. 39.
FIGS. 45 and 46 are view illustrating a manufacturing method of a display device according to an embodiment.
FIGS. 47 and 48 are views illustrating a manufacturing method of a display device according to an embodiment.
FIG. 49 is a view illustrating an example of FIG. 48.
FIG. 50 is a view illustrating a manufacturing method of a display device according to an embodiment.
FIGS. 51 and 52 are views illustrating a manufacturing method of a display device according to an embodiment.
FIGS. 53 and 54 are views illustrating a manufacturing method of a display device according to an embodiment.

### DETAILED DESCRIPTION

Example embodiments of the present invention now will be described more fully hereinafter with reference to the accompanying drawings. This invention may, however, be embodied in many different forms, and should not necessarily be construed as limited to the embodiments set forth herein. Rather, these embodiments are provided so that this disclosure will be thorough and complete, and will fully convey the scope of the invention to those skilled in the art. Like reference numerals refer to like elements throughout the specification and the figures.

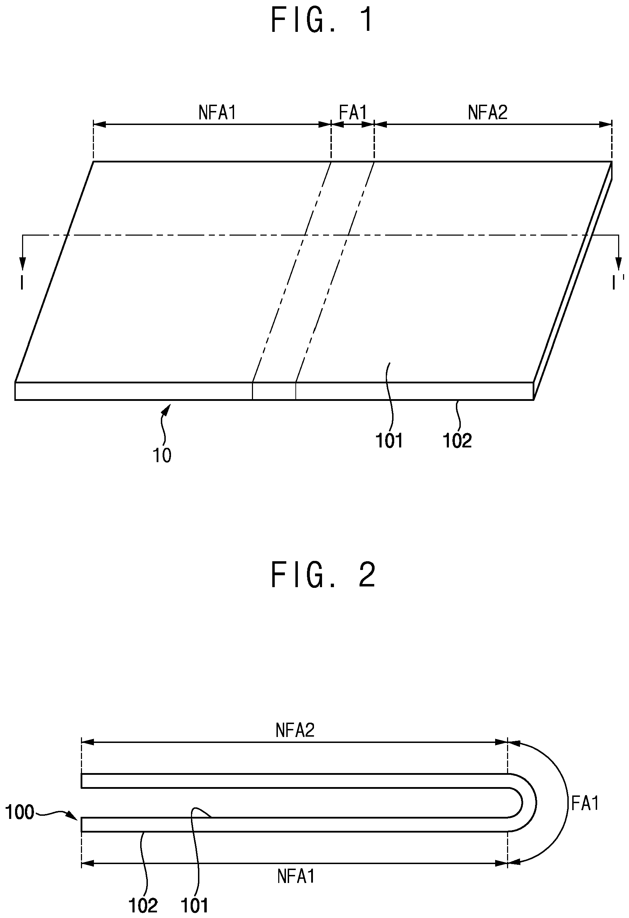

FIG. 1 is a perspective view illustrating an unfolded state of a display device according to an embodiment. FIG. 2 is a cross-sectional view illustrating a folded state of the display device of FIG. 1.

Referring to FIGS. 1 and 2, the display device 10 may include a display surface 101 and a non-display surface 102 opposite to the display surface 101. The display surface 101 may be a surface on which an image is displayed on the display device 10. The non-display surface 102 may be a surface on which an image is not displayed. In an embodiment, the image may also be displayed on the non-display surface 102. For example, the image may be displayed on a portion of the non-display surface 102. Alternatively, the image may be displayed on entire of the non-display surface 102.

The display device 10 may have a stacked structure. For example, the display device 10 may include several layers having different functions. Each of the several layers may be flexible, and thus the display device 10 may be flexible.

The display device 10 may include a first non-folding area NFA1, a second non-folding area NFA2, and a folding area FA disposed between the first non-folding area NFA1 and the second non-folding area NFA2.

The display device 10 might not be folded in the first non-folding area NFA1 and the second non-folding area NFA2. The display device 10 may have a flat surface in the first non-folding area NFA1 and the second non-folding area NFA2.

The display device 10 may be folded and unfolded in the folding area FA. The display device 10 may be folded (e.g., a folded state in FIG. 2) or unfolded (e.g., an unfolded state in FIG. 1) in the folding area FA. Also, the display device 10 may be in-folded or out-folded. For example, when the display device 10 is in-folded, the display surface 101 of the display device 10 may face itself. When the display device 10 is out-folded, the non-display surface 102 of the display device 10 may face itself.

However, the present invention is not necessarily limited thereto, and in an embodiment, the display device 10 may further include a third non-folding area adjacent to the second non-folding area NFA2. In addition, the display device 10 may further include a folding area between the second non-folding area NFA2 and the third non-folding area. Also, in an embodiment, a width of the folding area FA may be wide. Accordingly, the display device 10 may slide in the folding area FA, and thus an area of the display surface 101 may be adjusted.

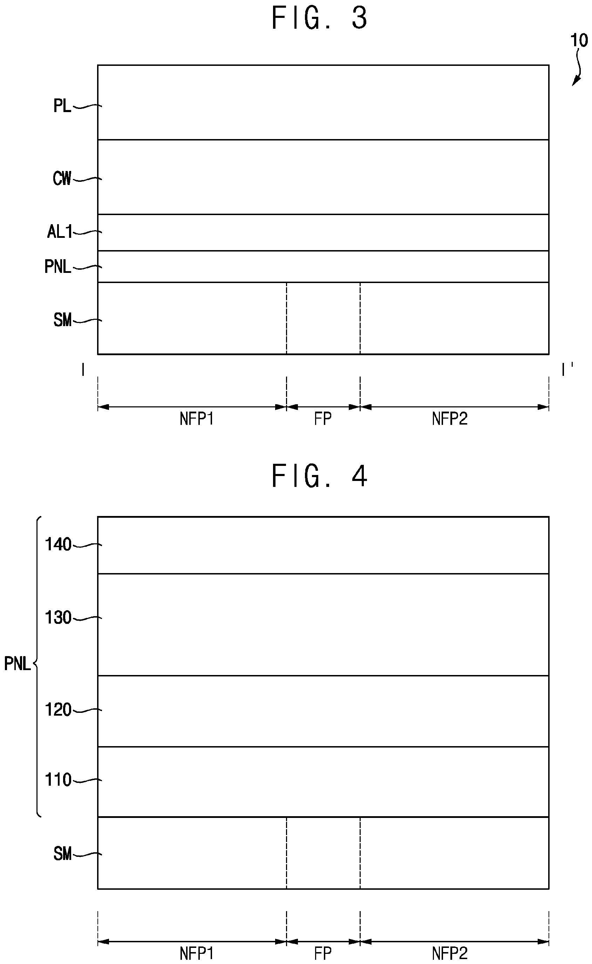

FIG. 3 is a cross-sectional view taken along line I-I' of FIG. 1. FIG. 4 is a cross-sectional view illustrating a support and a display panel of FIG. 3.

Further referring to FIG. 3, the display device 10 may include a support SM, a display panel PNL, a first adhesive layer AL1, a cover window CW, and a protective film PL. As described above, since the display device 10 can be folded or unfolded, each of the support SM, the display panel PNL, the first adhesive layer AL1, the cover window CW, and the protective film PL may be flexible.

The support SM may support the display panel PNL and may emit or disperse heat generated from the display panel PNL. Also, the support SM may prevent foreign matter from being introduced into the display panel PNL.

The support SM may include a first non-folding portion NFP1, a second non-folding portion NFP2, and a folding portion FP. The folding portion FP may be disposed between the first non-folding portion NFP1 and the second non-folding portion NFP2. The first non-folding portion NFP1 may overlap the first non-folding area NFA1, the second non-folding portion NFP2 may overlap the second non-folding area NFA2, and the folding portion FP may overlap the folding area FA.

Each of the first non-folding portion NFP1 and the second non-folding portion NFP2 may include glass.

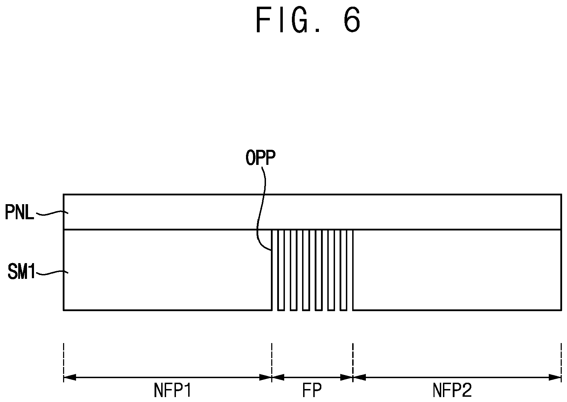

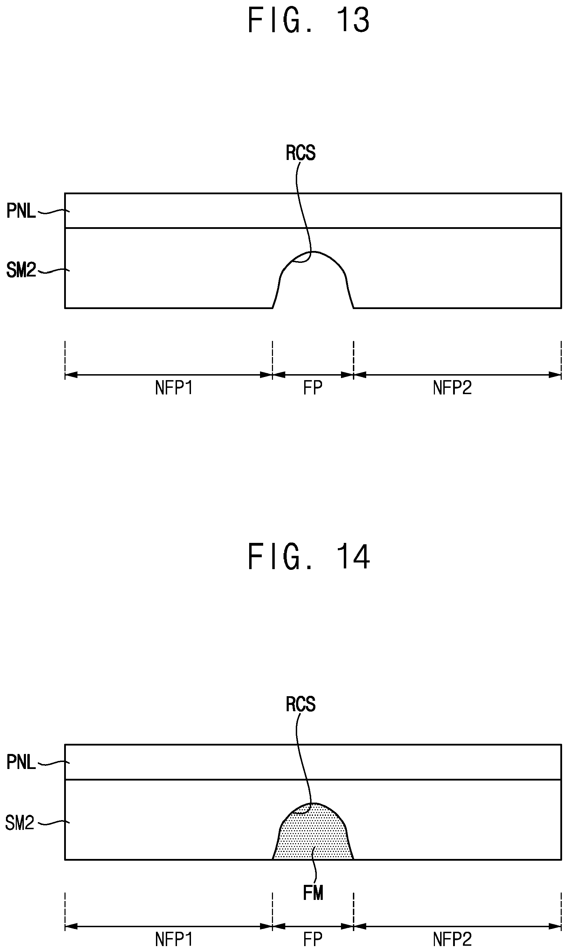

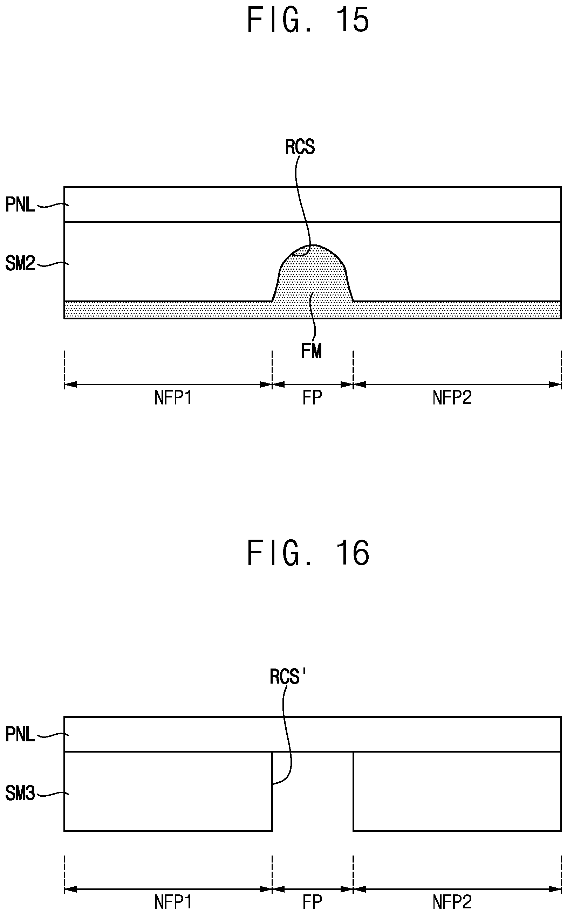

The folding portion FP may define an opening pattern (e.g., an opening pattern OPP of FIG. 6) or a recess (e.g., a recess RCS of FIG. 13 and a recess RCS' of FIG. 16). For example, one of the opening pattern, the groove, and the opening may be defined in the folding portion FP.

The display panel PNL may be disposed on the support SM. The display panel PNL may include a plurality of pixels, and an image may be generated by combining light emitted from each of the pixels.

Referring further to FIG. 4, since the display device 10 includes the first non-folding area NFA1, the second non-folding area NFA2, and the folding area FA, the display panel PNL may include the first non-folding area NFA1, the second non-folding area NFA2, and the folding area FA.

The display panel PNL may include a circuit element layer 110, a light emitting device layer 120, an encapsulation layer 130, and a touch sensing layer 140.

The circuit element layer 110 may be disposed on the support SM. The circuit element layer 110 may include insulating layers and conductive layers. The circuit element layer 110 may include at least one transistor. The light emitting device layer 120 may be formed on the circuit element layer 110. The light emitting device layer 120 may include at least one light emitting diode. The light emitting device layer 120 may emit light, and the circuit element layer 110 may drive the light emitting device layer 120.

The encapsulation layer 130 may be disposed on the light emitting device layer 120. The encapsulation layer ECP may prevent penetration of moisture and oxygen into the light emitting diode. The encapsulation layer 130 may include an organic encapsulation layer and/or an inorganic encapsulation layer.

The touch sensing layer 140 may be disposed on the encapsulation layer 130. The touch sensing layer 140 may include at least one touch electrode.

Referring back to FIG. 3, the first adhesive layer AL1 may be disposed on the display panel PNL. For example, the first adhesive layer AL1 may be disposed on the touch sensing layer 140.

The cover window CW may be disposed on the first adhesive layer AL1. The cover window CW may serve to protect the display panel PNL. The cover window CW may be made of a transparent material. The cover window CW may be bonded to the display panel PNL through the first adhesive layer AL1.

For example, the cover window CW may include an ultra-thin tempered glass. The ultra-thin tempered glass may be strengthened to have a predetermined stress profile therein. The ultra-thin tempered glass, which has been strengthened, may be more resistant to crack generation, propagation of cracks, damage, or the like due to external impact than before tempering. The ultra-thin tempered glass strengthened through the strengthening process may have various stresses for each area.

When the glass is made of an ultra-thin film or a thin film, it may be flexible and may be bent, folded, or rolled. The glass of the cover window CW may include soda lime glass, alkali alumino silicate glass, borosilicate glass, or lithium alumina silicate glass. The ultra-thin tempered glass of the cover window CW may be a thin glass which is chemically strengthened to have high strength. However, the present invention is not necessarily limited thereto, and the ultra-thin tempered glass of the cover window CW may be a thermally strengthened thin glass.

The protective film PL may be disposed on the cover window CW. The protective film PL may prevent shattering of the cover window CW, may absorb shock, may prevent stamping, may prevent accumulation of fingerprints, and/or may reduce glare. The protective film PL may include a transparent polymer film. The transparent polymer film that can be used as the protective film PL may be made of epoxy resin, polyurethane, polyester, polyethylene terephthalate, polyethylene naphthalate, polyimide, polyarylate, polycarbonate, polymethyl methacrylate, ethyl vinyl acetate, polyamide resin, or the like.

The present invention is not necessarily limited thereto, and the display device 10 may further include additional modules.

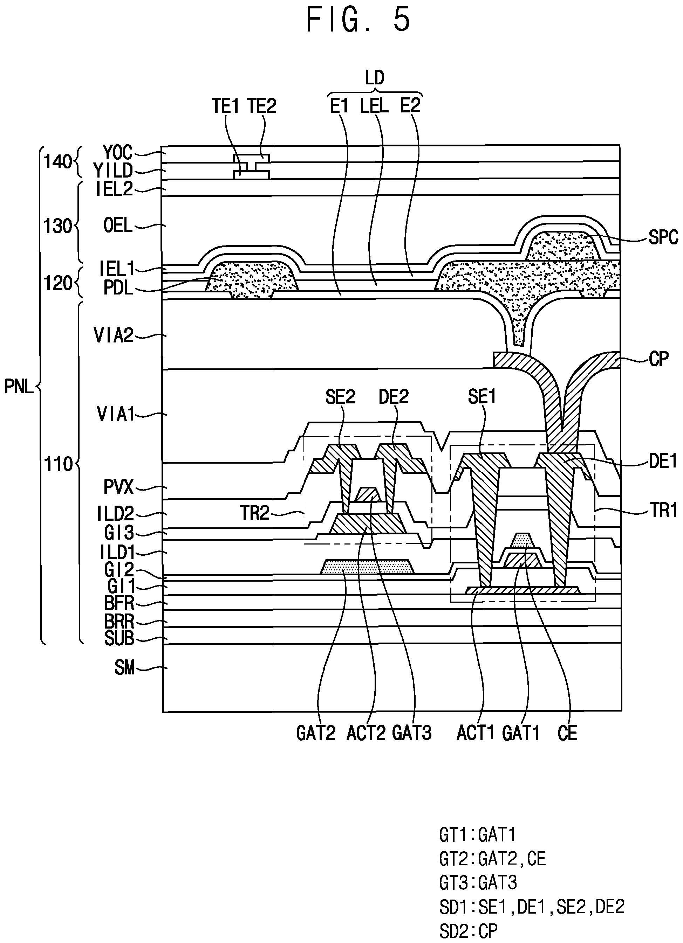

FIG. 5 is an enlarged view of a portion of FIG. 4.

Referring further to FIG. 5, the circuit element layer 110 may be disposed on the support SM. The circuit element layer 110 may include a base substrate SUB, a barrier layer BRR, a buffer layer BFR, a plurality of insulating layers, a first active layer ACT1, a first gate layer GT1, a second gate layer GT2, a second active layer ACT2, a third gate layer GT3, a first conductive layer SD1, and a second conductive layer SD2.

The base substrate SUB may be disposed on the support SM. The base substrate SUB may contact the support SM. The base substrate SUB may prevent permeation of external moisture. The base substrate SUB may include polyimide. The base substrate SUB may have a single layer or multiple layers.

The barrier layer BRR may be disposed on the base substrate SUB. The barrier layer BRR may prevent permeation of external moisture. For example, the barrier layer BRR may include silicon oxide.

The buffer layer BFR may be disposed on the barrier layer BRR. The buffer layer BFR may prevent diffusion of metal atoms or impurities from the support SM. For example, the buffer layer BFR may be a double layer. One layer may include silicon oxide. Another layer may include silicon nitride. However, the present invention is not necessarily limited thereto, and the buffer layer BFR may be made of one layer or two or more layers.

The first active layer ACT1 may be disposed on the buffer layer BFR. The first active layer ACT1 may be divided into a source area and a drain area doped with impurities and a channel area between the source area and the drain area. For example, the first active layer ACT1 may include a silicon semiconductor.

A first gate insulating layer GI1 may cover the first active layer ACT1 and may be disposed on the buffer layer BFR. The first gate insulating layer GI1 may include an inorganic material. For example, the first gate insulating layer GI1 may include silicon oxide.

The first gate layer GT1 may be disposed on the first gate insulating layer GI1. The first gate layer GT1 may include a first gate electrode GAT1. The first gate electrode GAT1 may overlap the channel area of the first active layer ACT1.

A second gate insulating layer GI2 may cover the first gate layer GT1 and may be disposed on the first gate insulating layer GI1. The second gate insulating layer GI2 may include an inorganic material. For example, the second gate insulating layer GI2 may include silicon nitride.

The second gate layer GT2 may be disposed on the second gate insulating layer GI2. The second gate layer GT2 may include a capacitor electrode CE and a second gate electrode GAT2. The capacitor electrode CE may overlap the first gate electrode GAT1. The capacitor electrode CE and the first gate electrode GAT1 may constitute a first storage capacitor. The second gate electrode GAT2 may be spaced apart from the capacitor electrode CE.

A first interlayer insulating layer ILD1 may cover the second gate layer GT2 and may be disposed on the second gate insulating layer GI2. The first interlayer insulating layer ILD 1 may include a double layer. One layer may include silicon oxide and another layer may include silicon nitride. However, the present invention is not necessarily limited thereto, and the first interlayer insulating layer ILD1 may be formed of one layer or two or more layers.

The second active layer ACT2 may be disposed on the first interlayer insulating layer ILD1. The second active layer ACT2 may be divided into a source area and a drain area doped with impurities and a channel area between the source area and the drain area. For example, the second active layer ACT2 may include an oxide semiconductor. For example, the second active layer ACT2 may include a material that is different from a material of the first active layer ACT1. However, the present invention is not necessarily limited thereto, and the second active layer ACT2 may include a same material as the first active layer ACT1.

A third gate insulating layer GI3 may cover the second active layer ACT2 and may be disposed on the first interlayer insulating layer ILD1. The third gate insulating layer GI3 may include an inorganic material. For example, the third gate insulating layer GI3 may include silicon oxide.

The third gate layer GT3 may be disposed on the third gate insulating layer GI3. The third gate layer GT3 may include a third gate electrode GAT3. The third gate electrode GAT3 may overlap the channel area of the second active layer ACT2. The third gate electrode GAT3 may overlap the second gate electrode GAT2. The third gate electrode GAT3 and the second gate electrode GAT2 may constitute a second storage capacitor. However, the present invention is not necessarily limited thereto.

The second interlayer insulating layer ILD2 may cover the third gate layer GT3 and may be disposed on the third gate insulating layer GI3. The second interlayer insulating layer ILD2 may be a double layer. One layer may include silicon oxide and another layer may include silicon nitride. However, the present invention is not necessarily limited thereto, and the second interlayer insulating layer ILD2 may be formed of one layer or two or more layers.

The first conductive layer SD1 may be disposed on the second interlayer insulating layer ILD2. The first conductive layer SD1 may include a first source electrode SE1, a first drain electrode DE1, a second source electrode SE2, and a second drain electrode DE2. The first source electrode SE1 and the first drain electrode DE1 may be electrically connected to the first active layer ACT1. The second source electrode SE2 and the second drain electrode DE2 may be electrically connected to the second active layer ACT2.

The first active layer ACT1, the first gate electrode GAT1, the first source electrode SE1, and the first drain electrode DE1 may constitute a first transistor TR1. The second active layer ACT2, the third gate electrode GAT3, the second source electrode SE2, and the second drain electrode DE2 may constitute a second transistor TR2.

A passivation layer PVX may cover the first conductive layer SD1 and may be disposed on the second interlayer insulating layer ILD2. The passivation layer PVX may include an inorganic material. For example, the passivation layer PVX may include silicon nitride.

A first via insulating layer VIA1 may be disposed on the passivation layer PVX. The first via insulating layer VIA1 may include an organic material. For example, the first via insulating layer VIA1 may include polyimide. The first via insulating layer VIA1 may planarize an upper surface of a stacked structure.

The second conductive layer SD2 may be disposed on the first via insulating layer VIA1. The second conductive layer SD2 may include a connection electrode CP. The connection electrode CP may contact the first drain electrode DE1 of the first transistor TR1. The connection electrode CP may connect the light emitting diode LD and the first transistor TR1.

A second via insulating layer VIA2 may be disposed on the first via insulating layer VIA1. The second via insulating layer VIA2 may include an organic material. For example, the second via insulation layer VIA2 may include polyimide. The second via insulating layer VIA2 may planarize an upper surface of the stacked structure.

The light emitting device layer 120 may be disposed on the circuit element layer 110. The light emitting device layer 120 may include at least one light emitting diode LD and a pixel defining layer PDL. The light emitting diode LD may include a first electrode E1, an emission layer LEL, and a second electrode E2.

The first electrode E1 may be disposed on the second via insulating layer VIA2. The first electrode E1 may contact the connection electrode CP. The first electrode E1 may be electrically connected to the first transistor TR1 through the connection electrode CP.

The pixel defining layer PDL may be disposed on the second via insulating layer VIA2. An opening exposing an upper surface of the first electrode E1 may be disposed in the pixel defining layer PDL. The pixel defining layer PDL may include an organic material or an inorganic material. For example, the pixel defining layer PDL may include polyimide.

The spacer SPC may be disposed on the pixel defining layer PDL. The spacer SPC may include an organic material or an inorganic material. The spacer SPC may maintain a gap between the encapsulation layer ECP and the support SM.

The spacer SPC may include an organic material or an inorganic material. The spacer SPC may include a same material as the pixel defining layer PDL. For example, the pixel defining layer PDL and the spacer SPC may include an organic material such as polyimide. Also, the pixel defining layer PDL and the spacer SPC may be simultaneously formed using a halftone mask. However, embodiments according to the present invention are not necessarily limited thereto, and the spacer SPC may be formed of a material that is different from a material of the pixel defining layer PDL. The spacer SPC may be formed after the pixel defining layer PDL is formed.

The emission layer LEL may be disposed on the first electrode E1. The emission layer LEL may be disposed in the opening formed in the pixel defining layer PDL. In an embodiment, the emission layer LEL may have a multilayer structure including a hole injection layer, a hole transport layer, an organic light emitting layer, an electron transport layer, and an electron injection layer. The organic light emitting layer may include a light emitting material.

The second electrode E2 may cover the emission layer LEL and may be disposed on the pixel defining layer PDL and the spacer SPC. In an embodiment, the second electrode E2 may have a plate shape. In addition, the second electrode E2 may transmit or reflect light. For example, the second electrode E2 may include metal.

The encapsulation layer 130 may be disposed on the light emitting device layer 120. The encapsulation layer ECP may prevent penetration of moisture and oxygen into the light emitting diode LD. For example, the encapsulation layer ECP may include a first inorganic encapsulation layer IEL1, an organic encapsulation layer OEL, and a second inorganic encapsulation layer IEL2.

The first inorganic encapsulation layer IEL1 may be formed with substantially a same thickness on the second electrode E2 along a profile of the second electrode E2. The organic encapsulation layer OEL may be formed on the first inorganic encapsulation layer IEL1, and may have a substantially flat upper surface without creating a step around the first inorganic encapsulation layer IEL1. The second inorganic encapsulation layer IEL2 may be formed on the organic encapsulation layer OEL.

The touch sensing layer 140 may be disposed on the encapsulation layer 130. The touch sensing layer 140 may include a first touch electrode TE1, a touch insulating layer YILD, a second touch electrode TE2, and a touch planarization layer YOC.

The touch insulating layer YILD may be disposed on the first touch electrode TE1, the second touch electrode TE2 may be disposed on the touch insulating layer YILD, and the touch planarization layer YOC may be disposed on the second touch electrode TE2. The touch planarization layer YOC may have a substantially flat upper surface. The touch planarization layer YOC may be substantially parallel to an upper surface of the light emitting diode LD. The second touch electrode TE2 may be electrically connected to the first touch electrode TE1 through a contact hole. The touch sensing layer 140 may function as an input of the display device 10.

FIG. 6 is a cross-sectional view illustrating a display panel and a support of FIG. 4.

Referring to FIGS. 4 and 6, the support SM1 may include the first non-folding portion NFP1, the second non-folding portion NFP2, and the folding portion FP. The first non-folding portion NFP1 and the second non-folding portion NFP2 may include glass. The folding portion FP may include glass and may include an opening pattern OPP. An inside of the opening pattern OPP may remain empty. However, the present invention is not necessarily limited thereto.

In an embodiment, the support SM1 may include glass, and since the support SM1 contacts the display panel PNL, wrinkles might not occur in the folding area FA of the display device 10. For example, since there is no gap between the display panel PNL and the support SM1, wrinkles may be prevented from occurring in the display device 10 and reliability may be increased.

Since the support SM1 includes glass having a low density, the display device 10 may be reduced in weight. In addition, since the support SM1 includes glass, a surface quality of the support SM1 may be increased, and an impact resistance of the support SM1 may be increased so that deformation of the display panel PNL is prevented.

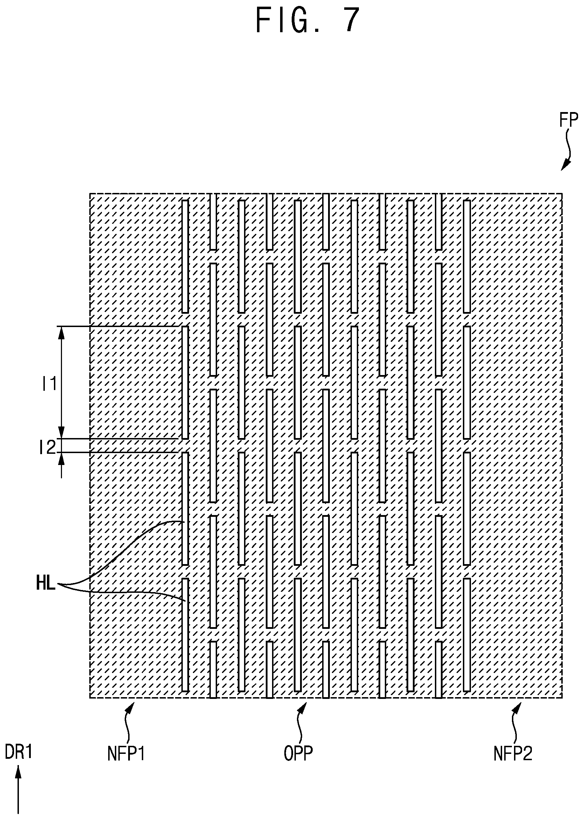

FIGS. 7 to 10 are plan views illustrating a support of FIG. 6.

Further referring to FIGS. 7 to 10, the opening pattern OPP may include a plurality of openings HL. Each of the plurality of openings HL may have a rectangle shape, a rhombus shape, an ellipse shape, a wavy shape, or a shape of a rectangle with rounded corners. The opening pattern OPP may be formed by removing a portion of the folding portion FP.

Referring to FIG. 7, the opening pattern OPP of the folding portion FP, according to an embodiment, may include the openings HL. Each of the openings HL may have a same shape. For example, each of the openings HL may have a same rectangular shape. Each of the openings HL may have a shape extending in the first direction DR1. For example, a long axis of each of the openings HL may be parallel to the first direction DR1. The rectangular shape may have a specific length 11 and may be spaced apart from each other by a specific interval l2 on a same line. Rectangular shapes arranged in a same column may be aligned with or staggered with rectangular shapes arranged in adjacent columns.

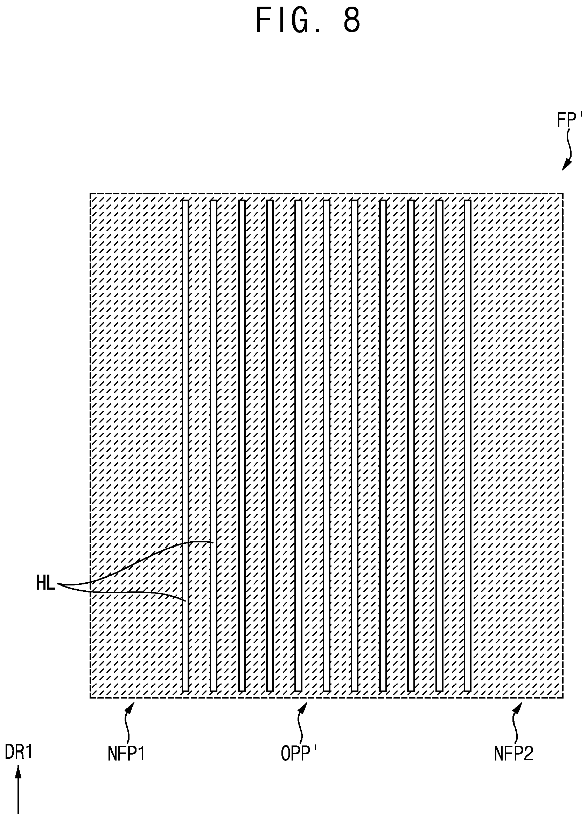

Referring to FIG. 8, the opening pattern OPP' of the folding portion FP' may include the openings HL. Each of the openings HL may have a same shape. For example, each of the openings HL may have a same rectangular shape, and each of the openings HL may have a shape extending in the first direction DR1. In the opening pattern OPP' of the folding portion FP', only one opening extending in the first direction DR1 may be disposed in a same column.

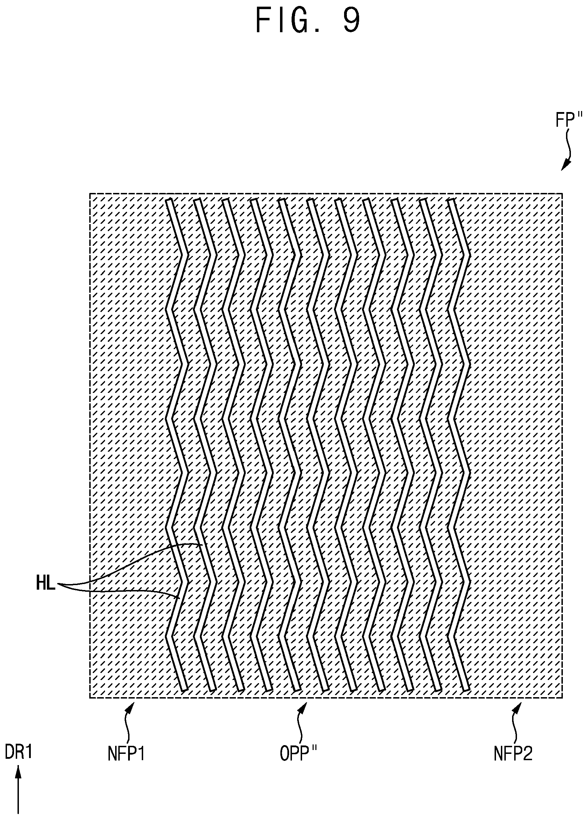

Referring to FIG. 9, the opening pattern OPP" of the folding portion FP" may include the openings HL. Each of the openings HL may have a wavy shape. Only one opening extending in the first direction DR1 may be disposed in the opening pattern OPP".

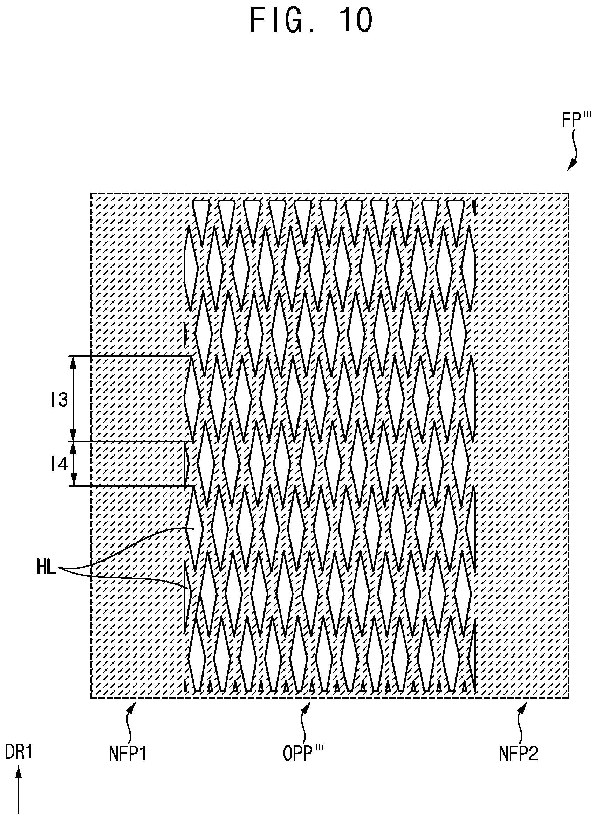

Referring to FIG. 10, the opening pattern OPP"" of the folding portion FP"" may include the openings HL. Each of the openings HL may have a rhombus shape. The rhombus may have a specific length 13 and may be spaced apart from each other by a specific interval l4 on a same line. The rhombuses arranged in a same column may be aligned with or staggered with the rhombuses arranged in an adjacent column.

However, embodiments according to the present invention are not necessarily limited thereto, and in embodiments, a shape or size of each of the openings HL may be different from each other. Also, in an embodiment, the openings HL may include a rectangular shape with rounded corners, an elliptical shape, or the like other than the above shapes.

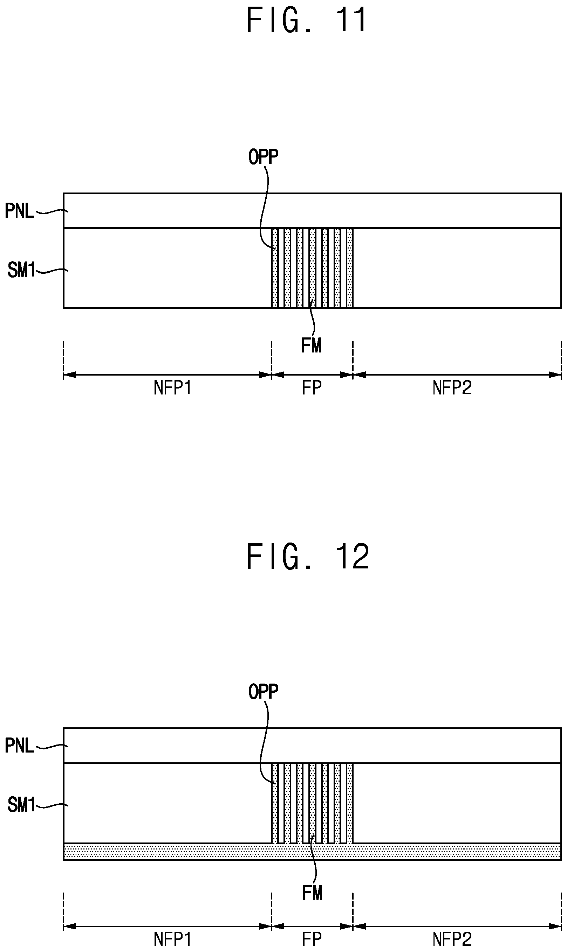

FIGS. 11 and 12 are cross-sectional views illustrating examples of FIG. 6.

Referring to FIGS. 3 and 11, the display device 10 may further include a filling material FM. The filling material FM may overlap the folding portion FP and fill the opening pattern OPP defined in the folding portion FP.

The filling material FM may include a silicon-based resin. In addition, the filling material FM may include a thermosetting resin. However, the present invention is not necessarily limited thereto.

Referring to FIGS. 3 and 12, the display device 10 may further include a filling material FM. The filling material FM may overlap the folding portion FP and fill the opening pattern OPP defined in the folding portion FP. Also, the filling material FM may be further disposed under the support SM2. For example, the filling material FM may fill the opening pattern OPP and may be further disposed under the first non-folding portion NFP1 and the second non-folding portion NFP2.

In an embodiment, the display device 10 may include the filling material FM further disposed under the support SM2, so that a boundary between the folding portion FP and the first non-folding portion NFP1 and a boundary between the folding portion and the second non-folding portion NFP2 may be prevented from being visually recognized.

FIG. 13 is a cross-sectional view illustrating an example of FIG. 6.

The supporting SM2 described with reference to FIG. 13 may be substantially same as the supporting SM1 described with reference to FIG. 6 except for the folding portion FP.

Referring to FIG. 13, the support SM2 may include a first non-folding portion NFP1, a second non-folding portion NFP2, and a folding portion FP. The first non-folding portion NFP1 and the second non-folding portion NFP2 may include glass. The folding portion FP may include glass and may define a recess RCS. For example, the folding portion FP may define the recess RCS having a groove shape.

Inside of the recess RCS may remain empty. However, the present invention is not necessarily limited thereto.

FIGS. 14 and 15 are cross-sectional views illustrating examples of FIG. 13.

The filling materials described with reference to FIGS. 14 and 15 may correspond to the filling materials described with reference to FIGS. 11 and 12, respectively. Accordingly, to the extent that a description of an element is not provided in detail herein, it may be assumed that the element is at least similar to a corresponding element that has been described elsewhere within the present disclosure.

Referring to FIGS. 3 and 14, the display device 10 may further include a filling material FM. The filling material FM may overlap the folding portion FP and fill the recess RCS having the groove shape defined in the folding portion FP.

Referring to FIGS. 3 and 15, the display device 10 may further include a filling material FM. The filling material FM may overlap the folding portion FP and fill the recess RCS defined in the folding portion FP. Also, the filling material FM may be further disposed under the support SM2. For example, the filling material FM may fill the recess RCS having the groove shape and may be further disposed under the first non-folding portion NFP1 and the second non-folding portion NFP2.

FIG. 16 is a cross-sectional view illustrating an example of FIG. 13.

The support SM3 described with reference to FIG. 16 may be substantially same as the support SM2 described with reference to FIG. 13 except for the folding portion FP.

Referring to FIG. 16, the support SM3 may include a first non-folding portion NFP1, a second non-folding portion NFP2, and a folding portion FP. The first non-folding portion NFP1 and the second non-folding portion NFP2 may include glass. The folding portion FP may define a recess RCS'. For example, the folding portion FP may define the recess RCS' having an opening shape. For example, the recess RCS' may be formed by penetrating the folding portion FP.

Inside of the recess RCS' may remain empty. However, the present invention is not necessarily limited thereto.

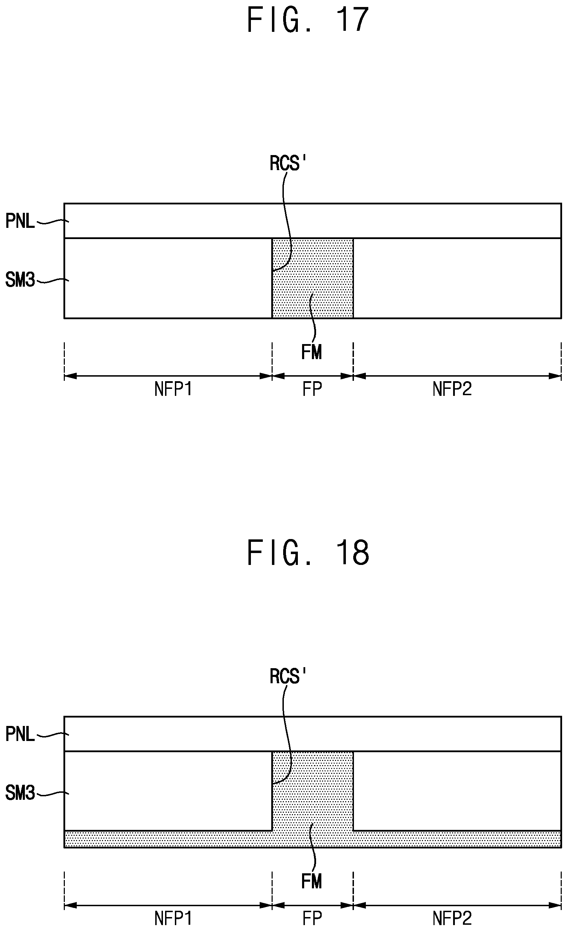

FIGS. 17 and 18 are cross-sectional views illustrating examples of FIG. 16.

The filling materials described with reference to FIGS. 17 and 18 may correspond to the filling materials described with reference to FIGS. 14 and 15, respectively. Accordingly, to the extent that a description of an element is not provided in detail herein, it may be assumed that the element is at least similar to a corresponding element that has been described elsewhere within the present disclosure.

Referring to FIGS. 3 and 17, the display device 10 may further include a filling material FM. The filling material FM may overlap the folding portion FP and fill the recess RCS' having an opening shape defined in the folding portion FP.

Referring to FIGS. 3 and 18, the display device 10 may further include a filling material FM. The filling material FM may overlap the folding portion FP and fill the recess RCS' defined in the folding portion FP. In addition, the filling material FM may be further disposed under the support SM3. For example, the filling material FM may fill the recess RCS' having the opening shape and may be further disposed under the first non-folding portion NFP1 and the second non-folding portion NFP2.

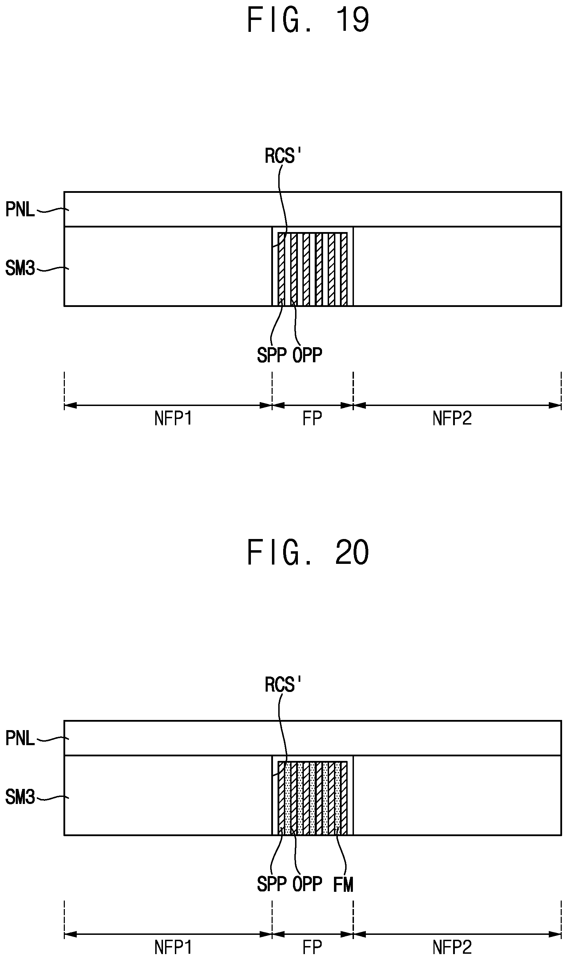

FIG. 19 is a cross-sectional view illustrating an example of FIG. 16.

Referring to FIGS. 3 and 19, the display device 10 may further include a support pattern SPP.

The support pattern SPP may overlap the folding area FA and may be disposed within the recess RCS' of the folding portion FP. For example, the support pattern SPP may be disposed in the recess RCS' of the folding portion FP in a state of being separated from the recess RCS'. For example, the support pattern SPP may be disposed in the recess RCS' without an additional adhesive. For example, the support pattern SPP may be attached to the support SM3 or the display panel PNL through an adhesive.

The support pattern SPP may define an opening pattern OPP so that the display device 10 can be easily folded.

The support pattern SPP may include a material that is different from a material of the support SM3. For example, the support pattern SPP may include stainless steel, carbon fiber, and/or fiberglass.

In an embodiment, since the support SM3 further includes the support pattern SPP overlapping the folding portion FP, durability of the folding area FA of the display device 10 may be increased, deformation of the display device 10 may be prevented, and reliability may be increased.

FIG. 20 is a cross-sectional view illustrating an example of FIG. 19.

The display device described with reference to FIG. 20 may be substantially same as the display device described with reference to FIG. 19 except for the filling material FM. Accordingly, to the extent that a description of an element is not provided in detail herein, it may be assumed that the element is at least similar to a corresponding element that has been described elsewhere within the present disclosure.

Referring to FIGS. 3 and 20, the display device 10 may further include a filling material FM. For example, the filling material FM may overlap the folding portion FP and fill the opening pattern OPP defined in the support pattern SPP.

However, the present invention is not necessarily limited thereto, and in an embodiment, the filling material FM may overlap the folding portion FP and fill the opening pattern OPP defined in the support pattern SPP. Also, the filling material FM may be further disposed under the support SM3.

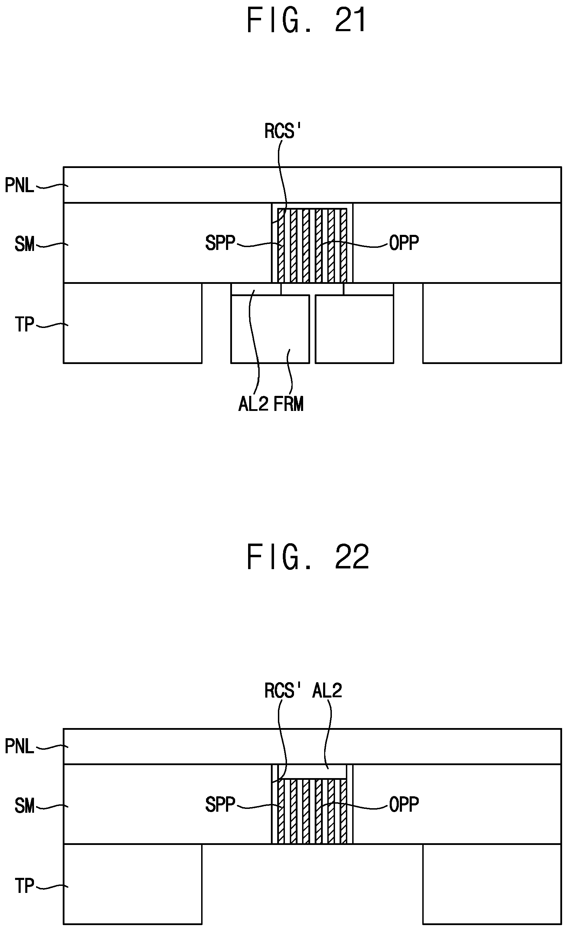

FIGS. 21 and 22 are cross-sectional views illustrating examples of FIG. 19.

Referring to FIGS. 3 and 21, the display device 10 may further include a support pattern SPP, a second adhesive layer AL2, a frame FRM, and a tape TP.

The support pattern SPP may overlap the folding portion FP of the support SM3 and may be disposed in the recess RCS'.

The second adhesive layer AL2 and the frame FRM may be disposed under the support pattern SPP. The frame FRM may be disposed under the second adhesive layer AL2 and may be attached to the support pattern SPP and the support SM3 through the second adhesive layer AL2. The frame FRM may support the support pattern SPP under the support pattern SPP. For example, the frame FRM may include stainless steel.

The tape TP may be disposed under the support SM3 and may be disposed adjacent to the support pattern SPP. The tape TP may overlap the first non-folding portion NFP1 and the second non-folding portion NFP2. The tape TP may attach the support SM3 and an additional lower structure to each other.

Referring to FIGS. 3 and 22, the display device 10 may further include a support pattern SPP and a second adhesive layer AL2.

The support pattern SPP may overlap the folding portion FP of the support SM3 and may be disposed in the recess RCS'.

The second adhesive layer AL2 may be disposed on the support pattern SPP. For example, the support pattern SPP may be attached to the support SM3 or the display panel PNL through the second adhesive layer AL2.

The second adhesive layer AL2 may be a pressure sensitive adhesive (PSA), an optically clear resin (OCR), and/or an optically clear adhesive (OCA). However, the present invention is not necessarily limited thereto.

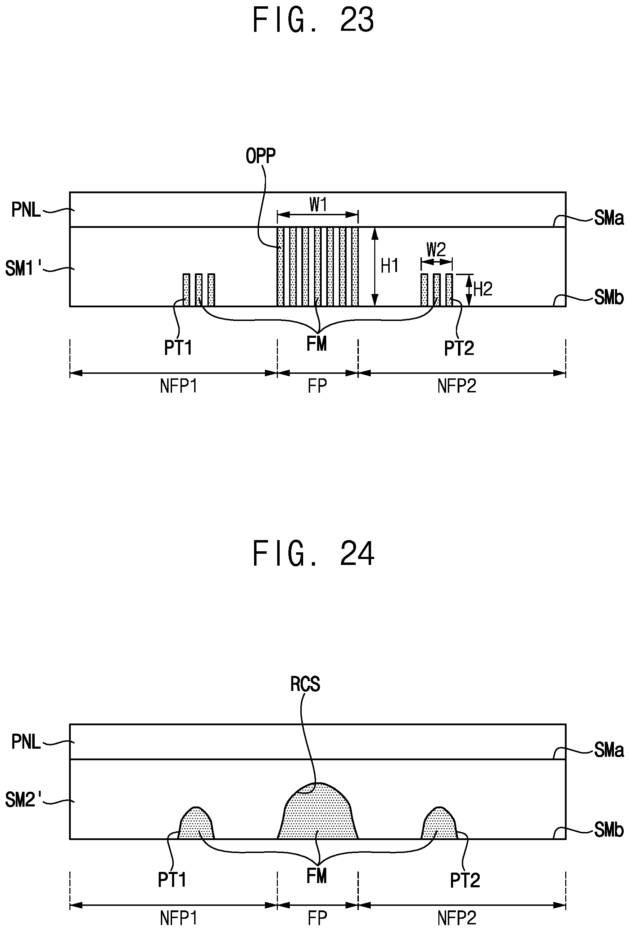

FIG. 23 is a cross-sectional view illustrating a portion of a display device according to an embodiment.

Referring to FIG. 23, the display device 10 may include a support SM1'. The support SM1' may include a first non-folding portion NFP1, a second non-folding portion NFP2, and a folding portion FP. The folding portion FP may define an opening pattern OPP.

In an embodiment, the first non-folding portion NFP1 may further define a first pattern PT1. The second non-folding portion NFP2 may further define a second pattern PT2. Each of the first pattern PT1 and the second pattern PT2 may be adjacent to the folding portion FP. Each of the first pattern PT1 and the second pattern PT2 may be an inverse curvature part having an inverse curvature opposite to a curvature of the folding portion FP.

The support SM1 ' may include a first surface SMa and a second surface SMb. The first surface SMa may be a surface adjacent to the display panel (e.g., the circuit element layer 110), and the second surface SMb may be spaced apart from the display panel PNL, may be a surface opposite to the first surface SMa. Each of the first pattern PT1 and the second pattern PT2 may be defined on the second surface SMb. Each of the first pattern PT1 and the second pattern PT2 may have an opening pattern OPP. However, the present invention is not necessarily limited thereto.

A height H2 of each of the first pattern PT1 and the second pattern PT2 may be smaller than a height H1 of the folding portion FP. A width W2 of each of the first pattern PT1 and the second pattern PT2 may be smaller than a width W1 of the folding portion FP. Therefore, since the first pattern PT1 and the second pattern PT2 do not penetrate the support SM1', the first pattern PT1 and the second pattern PT2 may have an inverse curvature of an opposite shape to a curvature of the folding portion FP.

The display device 10 may further include a filling material FM. The filling material FM may fill the folding portion FP, the first pattern PT1, and the second pattern PT2. However, the present invention is not necessarily limited thereto, and the filling material FM may be omitted in the display device 10.

FIGS. 24 to 26 are cross-sectional views illustrating examples of FIG. 23.

Referring to FIGS. 3 and 24, the support SM2' may include a first non-folding portion NFP1, a second non-folding portion NFP2, and a folding portion FP. The folding portion FP may define a recess RCS having a groove shape. For example, the recess RCS might not penetrate the support SM2'. Also, the first non-folding portion NFP1 may further define a first pattern PT1. The second non-folding portion NFP2 may further define a second pattern PT2.

In an embodiment, each of the first pattern PT1 and the second pattern PT2 may have a recess shape. For example, each of the first pattern PT1 and the second pattern PT2 may have a groove shape. However, the present invention is not necessarily limited thereto.

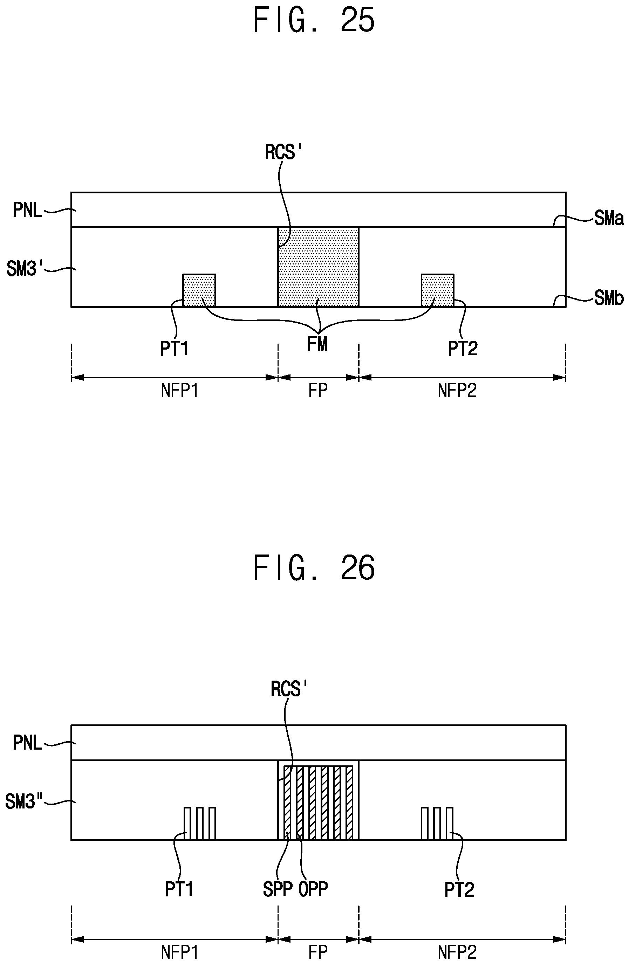

Referring to FIGS. 3 and 25, the support SM3' may include a first non-folding portion NFP1, a second non-folding portion NFP2, and a folding portion FP. The folding portion FP may define a recess RCS' having an opening shape. For example, the recess RCS' may penetrate the support SM3. Also, the first non-folding portion NFP1 may further define a first pattern PT1. The second non-folding portion NFP2 may further define a second pattern PT2.

In an embodiment, each of the first pattern PT1 and the second pattern PT2 may have a recess shape. For example, each of the first pattern PT1 and the second pattern PT2 may have a groove shape. However, the present invention is not necessarily limited thereto.

Referring to FIGS. 3 and 26, the support SM3" may include a first non-folding portion NFP1, a second non-folding portion NFP2, and a folding portion FP. The folding portion FP may define a recess RCS' having an opening shape. Also, the first non-folding portion NFP1 may further define a first pattern PT1. The second non-folding part NFP2 may further define a second pattern PT2. Each of the first pattern PT1 and the second pattern PT2 may have a shape of an opening pattern. However, the present invention is not necessarily limited thereto.

In an embodiment, the display device 10 may further include a support pattern SPP. The support pattern SPP may overlap the folding area FA and may be disposed in the recess RCS' of the folding portion FP.

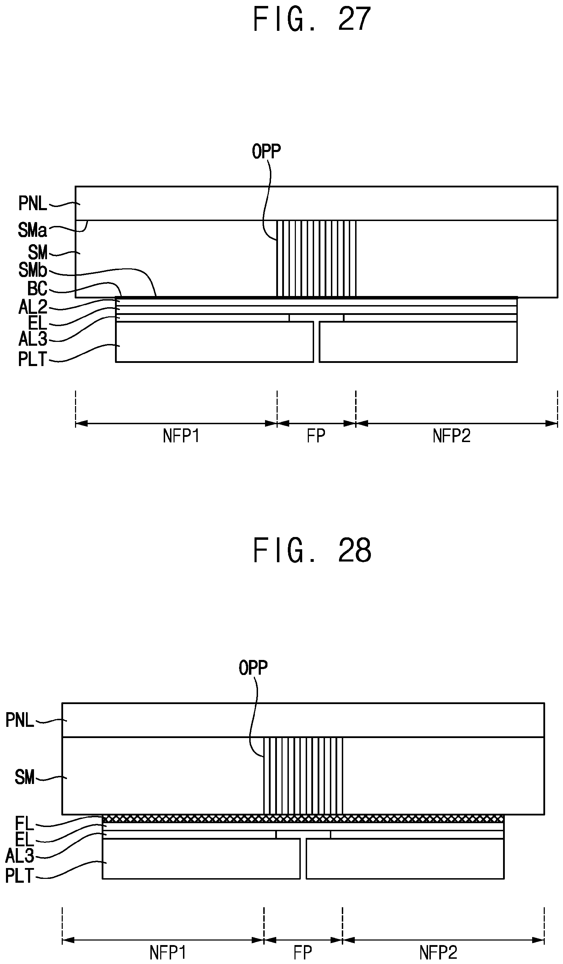

FIG. 27 is a cross-sectional view illustrating a portion of a display device according to an embodiment.

Referring to FIGS. 3 and 27 , the display device 10 may further include a second adhesive layer AL2, a third adhesive layer AL3, an elastic layer EL, and a plate PLT.

The second adhesive layer AL2 may be disposed under the support SM. The elastic layer EL may be disposed under the second adhesive layer AL2 and may be attached to the support SM through the second adhesive layer AL2. The third adhesive layer AL3 may be disposed under the elastic layer EL. The plate PLT may be disposed under the third adhesive layer AL3, and the plate PLT may be attached to the elastic layer EL through the third adhesive layer AL3.

The elastic layer EL may prevent the folding portion FP from being exposed while the display device 10 repeatedly folds and unfolds. Accordingly, the elastic layer EL may prevent foreign substances from penetrating into the folding portion FP. The elastic layer EL may include a material having a relatively high elasticity or high restoring force. For example, the elastic layer EL may include an elastic material such as silicone, urethane, or thermoplastic polyurethane (TPU).

The plate PLT may support the support SM under the support SM.

The support SM may include a first surface SMa and a second surface SMb. The second surface SMb may be a surface spaced apart from the display panel PNL, and the second adhesive layer AL2 may be attached thereto. A surface where the support SM and the second adhesive layer AL2 contact each other may be coated in black. For example, a black coating layer BC may be disposed on the second surface SMb of the support SM. For example, the second surface SMb of the support SM may be coated in black. For example, an upper surface of the second adhesive layer AL2 may be coated in black.

In an embodiment, since the black coating layer BC may be disposed between the support SM and the second adhesive layer AL2, the visibility of reflections in the display device 10 may be reduced.

Meanwhile, a shape of the folding portion FP shown in FIG. 27 is only an example, and may be variously changed. The same applies below.

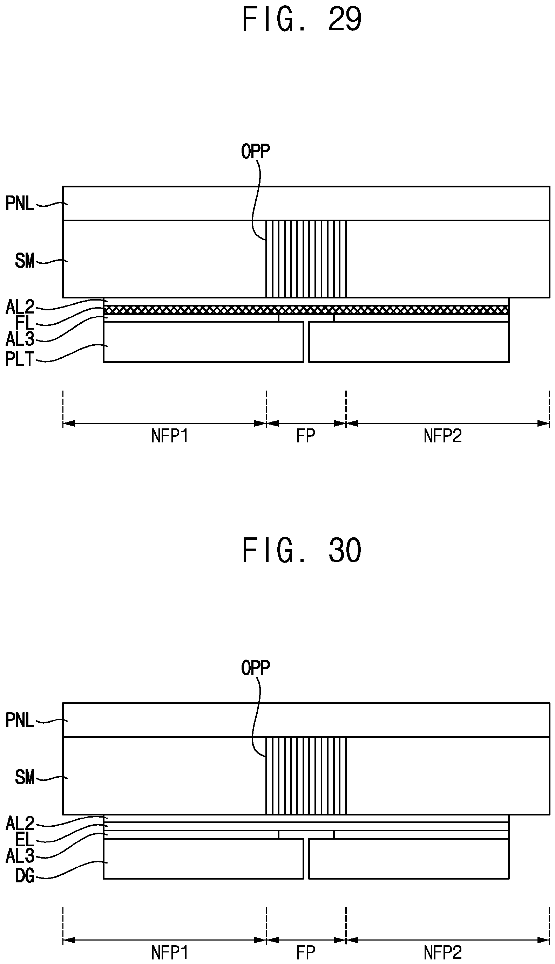

FIGS. 28 and 29 are cross-sectional views illustrating a portion of a display device according to embodiments.

The display device described with reference to each of FIGS. 28 and 29 may be substantially same as the display device described with reference to FIG. 27 except for coating and a functional layer FL. Accordingly, to the extent that a description of an element is not provided in detail herein, it may be assumed that the element is at least similar to a corresponding element that has been described elsewhere within the present disclosure.

Referring to FIGS. 3 and 28, the display device 10 may further include a functional layer FL, an elastic layer EL, a third adhesive layer AL3, and a plate PLT.

The functional layer FL may be disposed under the support SM. The elastic layer EL may be disposed under the second adhesive layer AL2 and may be attached to the support SM through the functional layer FL. The third adhesive layer AL3 may be disposed under the elastic layer EL. The plate PLT may be disposed under the third adhesive layer AL3, and the plate PLT may be attached to the elastic layer EL through the third adhesive layer AL3.

In an embodiment, the functional layer FL may include a black pigment or a black dye. For example, the functional layer FL may be an adhesive layer containing a black pigment or a black dye.

Referring to FIGS. 3 and 29, the display device 10 may further include a second adhesive layer AL2, a functional layer FL, a third adhesive layer AL3, and a plate PLT.

The second adhesive layer AL2 may be disposed under the support SM. The functional layer FL may be disposed under the second adhesive layer AL2 and may be attached to the support SM through the second adhesive layer AL2. The third adhesive layer AL3 may be disposed under the functional layer FL. The plate PLT may be disposed under the third adhesive layer AL3 and may be attached to the elastic layer EL through the third adhesive layer AL3.

In an embodiment, the functional layer FL may include a black pigment or a black dye. For example, the functional layer FL may be an elastic layer containing a black pigment or a black dye.

For example, the functional layer FL may include a black pigment or a polyimide containing a black dye. For example, the functional layer FL may include a material treated with a black primer.

FIG. 30 is a cross-sectional view illustrating a portion of a display device according to an embodiment.

Referring to FIGS. 3 and 30, the display device 10 may include a protective film PL, a cover window CW, a first adhesive layer AL1, a display panel PNL, a support SM, a second adhesive layer AL2, an elastic layer EL, a third adhesive layer AL3, and a digitizer DG.

The digitizer DG may be disposed under the support SM. The digitizer DG may be attached to the elastic layer EL through the third adhesive layer AL3. The digitizer DG, as an input device, may recognize location information on the display surface DS of the display device 10 indicated by a user. Accordingly, the display device 10 may provide an input to the user through the digitizer DG. The digitizer DG may recognize movement of an input device (e.g., a stylus pen) on the display surface DS of the display device 10 and convert it into a digital signal.

In an embodiment, since the support SM includes glass, the support SM may pass a magnetic field. Accordingly, the digitizer DG may be applied under the support SM.

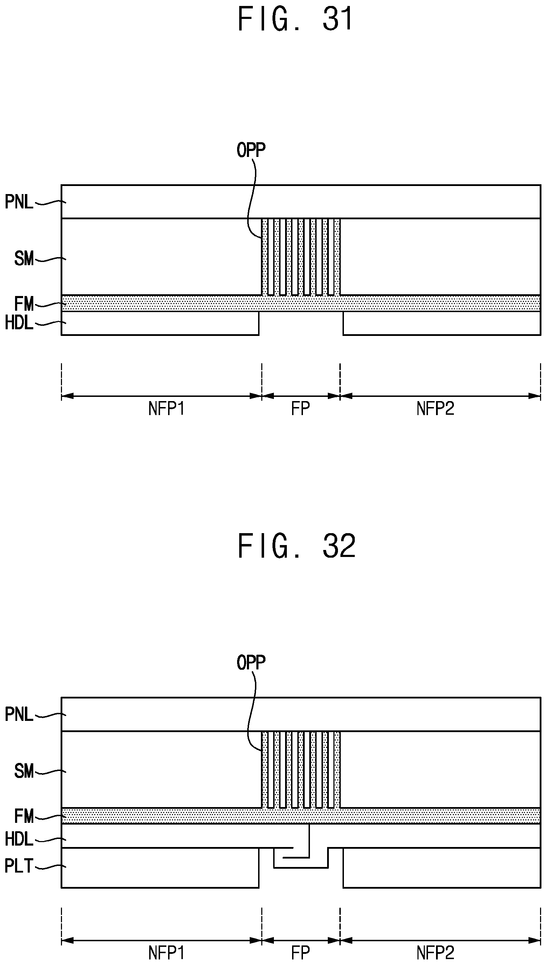

FIG. 31 is a cross-sectional view of a portion of a display device according to an embodiment.

Referring to FIGS. 3 and 31, the display device 10 may include a protective film PL, a cover window CW, a first adhesive layer AL1, a display panel PNL, a support SM, a filling material FM, and a heat dissipation layer HDL.

The filling material FM may fill an opening pattern OPP of the folding portion FP of the support SM. The filling material FM may be further disposed under the support SM. However, the present invention is not necessarily limited thereto, and the filling material FM may fill only the opening pattern OPP or may be omitted.

The heat dissipation layer HDL may be disposed under the support SM and the filling material FM. The heat dissipation layer HDL may prevent external heat from affecting the display panel PNL.

For example, the heat dissipation layer HDL may include an alloy. The alloy may include aluminum and/or copper.

FIG. 32 is a cross-sectional view illustrating an example of Fig. 31.

The display device described with reference to FIG. 32 may be substantially same as the display device described with reference to FIG. 31 except for a heat dissipation layer HDL and a plate PLT. Accordingly, to the extent that a description of an element is not provided in detail herein, it may be assumed that the element is at least similar to a corresponding element that has been described elsewhere within the present disclosure.

Referring to FIG. 32, the display device 10 may include a protective film PL, a cover window CW, a first adhesive layer AL1, a display panel PNL, a support SM, a filling material FM, a heat dissipation layer HDL and a plate PLT.

The heat dissipation layer HDL may be disposed under the filling material FM. The heat dissipation layer HDL may include wrinkles overlapping the folding portion FP. Therefore, when the display device 10 is folded, the heat dissipation layer HDL may also be easily folded.

For example, the heat dissipation layer HDL may include graphite.

The plate PLT may be disposed under the heat dissipation layer HDL. The plate PLT may support the support SM and the heat dissipation layer HDL. For example, the plate PLT may include stainless steel.

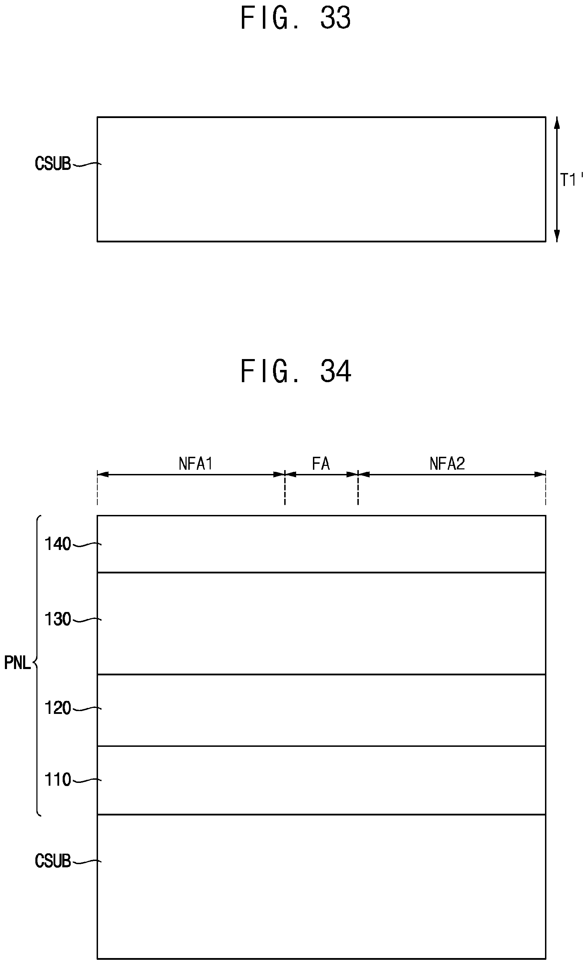

FIGS. 33 to 38 are views illustrating a manufacturing method of a display device according to an embodiment.

For example, a manufacturing method of the display device described with reference to FIGS. 33 to 38 may be a method of manufacturing the display device of FIG. 6.

Referring to FIG. 33, a carrier substrate CSUB may be formed. The carrier substrate CSUB may include glass. Also, a thickness T1' of the carrier substrate CSUB may be formed in a range of about 0.4T to about 0.5T. However, the present invention is not necessarily limited thereto.

Referring to FIG. 34, the display panel PNL may be formed on the carrier substrate CSUB. For example, the circuit element layer 110 may be formed on the carrier substrate CSUB. The light emitting device layer 120 may be formed on the circuit element layer 110. The encapsulation layer 130 may be formed on the light emitting device layer 120. The touch sensing layer 140 may be formed on the encapsulation layer 130. For example, the display panel PNL may directly contact the carrier substrate CSUB.

The display panel PNL may include the first non-folding area NFA1, the second non-folding area NFA2, and the folding area FA.

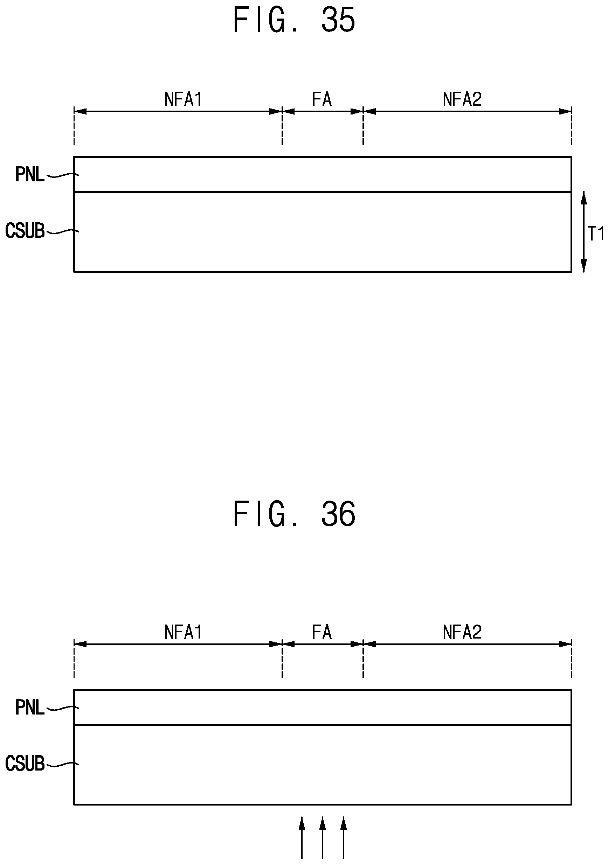

Referring to FIGS. 35 to 37, after the display panel PNL is formed, the support SM may be formed from the carrier substrate CSUB. For example, the carrier substrate CSUB may be slimmed to form the first non-folding portion NFP1 and the second non-folding portion NFP2, and a portion of the carrier substrate CSUB may be patterned to form the folding portion FP.

Referring to FIG. 35, the carrier substrate CSUB may be slimmed. For example, the carrier substrate CSUB may be slimmed entirely so that the first non-folding portion NFP1 overlaps the first non-folding area NFA1 and the second non-folding portion NFP2 overlaps the second non-folding area NFA2.

When the carrier substrate CSUB is slimmed, an overall thickness of the carrier substrate CSUB may uniformly decrease. For example, after the carrier substrate CSUB is slimmed, a thickness T1 of the carrier substrate CSUB may be smaller than the thickness T1' of the carrier substrate CSUB before the carrier substrate CSUB is slimmed. For example, after the carrier substrate CSUB is slimmed, the thickness T1 of the carrier substrate CSUB may be formed in a range of about 0.15T to about 0.2T. However, the present invention is not necessarily limited thereto.

The carrier substrate CSUB may include a first surface CSUBa and a second surface CSUBb. The first surface CSUBa may be adjacent to the display panel PNL, and the second surface CSUBb may be opposite to the first surface CSUBa. The slimming the carrier substrate CSUB may be a process of slimming the second surface CSUBb.

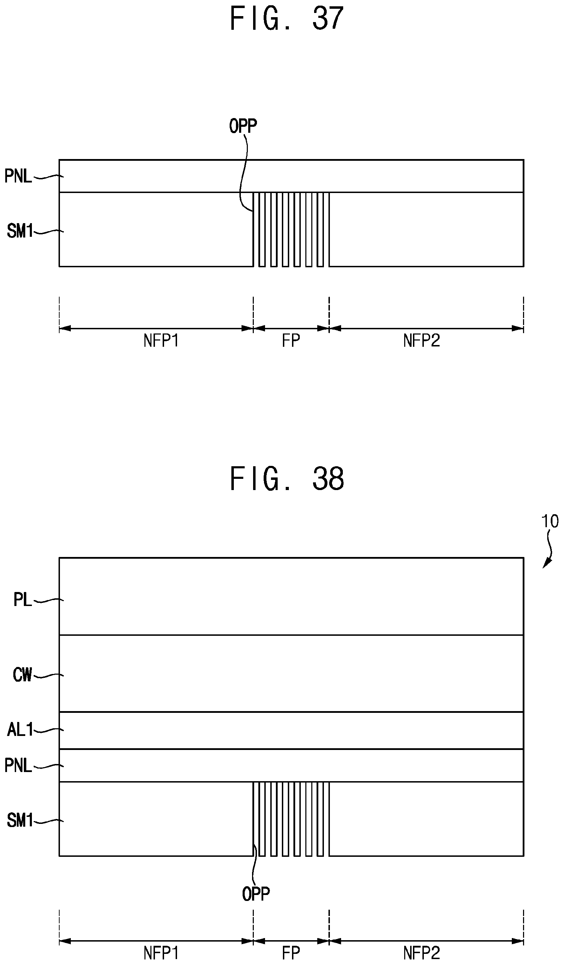

Further referring to FIGS. 36 and 37, a portion of the carrier substrate CSUB may be patterned. For example, a portion of the carrier substrate CSUB overlapping the folding area FA may be patterned to form the folding portion FP. The opening pattern OPP overlapping the folding area FA may be formed in the folding portion FP. Accordingly, the support SM1 including the folding portion FP, the first non-folding portion NFP1, and the second non-folding portion NFP2 may be formed.

In an embodiment, the carrier substrate CSUB may be patterned by a laser. As a wavelength of the laser is shorter, the display panel PNL might not be damaged. Accordingly, the carrier substrate CSUB may be patterned by an ultraviolet laser. However, a patterning method according to the present invention is not necessarily limited thereto.

Referring to FIG. 38, the first adhesive layer AL1 may be formed on the display panel PNL. The cover window CW may be formed on the first adhesive layer AL1. The protective film PL may be formed on the cover window CW. The cover window CW may include ultra-thin glass tempered glass. Ultra-thin glass can be strengthened into ultra-thin tempered glass through a tempering process. For example, the ultra-thin glass of the cover window CW may be formed of tempered glass through chemical strengthening.

The cover window CW and the protective film PL may be bonded to each other through a thermal compression process. For example, bonding force may be formed between the cover window CW and the protective film PL through the thermal compression bonding process. However, the present invention is not necessarily limited thereto, and the cover window CW and the protective film PL may be bonded to each other through an adhesive layer.

In an embodiment, the support SM1 may be formed by slimming and patterning the carrier substrate CSUB, and the display panel PNL may be directly formed on the support SM1. Accordingly, since steps of removing the carrier substrate CSUB and forming an additional support are not separately required, the manufacturing process of the display device can be simplified. Also, since the carrier substrate CSUB is slimmed to form the support SM1, the thickness of the display device 10 may be reduced.

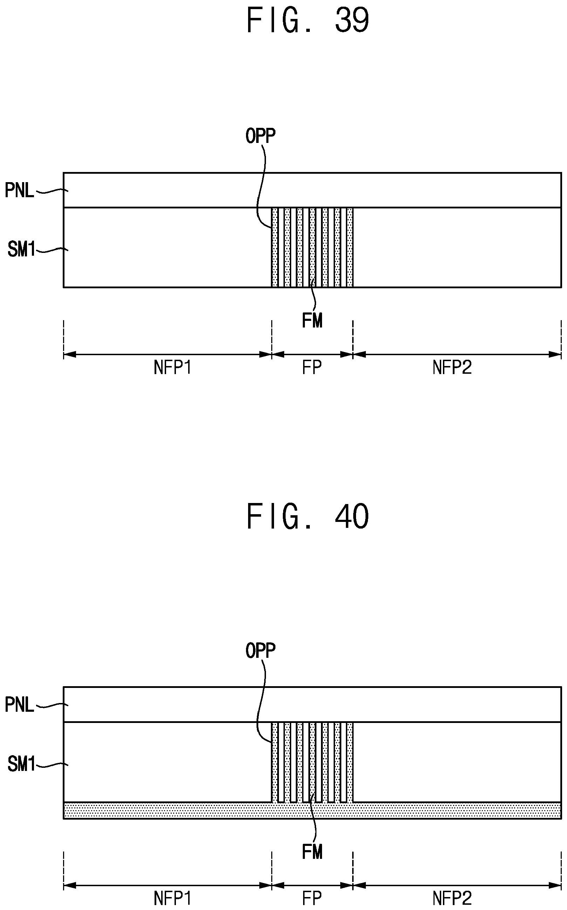

FIGS. 39 and 40 are views illustrating a manufacturing method of a display device according to an embodiment.

The manufacturing method of the display device described with reference to FIGS. 39 and 40 may be substantially same as the manufacturing method of the display device described with reference to FIGS. 33 to 38 except for filling the filling material FM. For example, a method of manufacturing the display device described with reference to FIG. 39 may be a method of manufacturing the display device of FIG. 11. Also, for example, a method of manufacturing the display device described with reference to FIG. 40 may be a method of manufacturing the display device of FIG. 12.

Referring to FIG. 39, the filling material FM may be further filled in the folding portion FP of the support SM1. For example, the filling material FM may fill the opening pattern OPP formed in the folding portion FP.

The filling material FM may be formed of a silicon-based resin. Also, the filling material FM may be applied to the folding portion FP through an inkjet process, a dispensing process, a molding process, and/or a screen printing process.

Referring to FIG. 40, the filling material FM may be further formed under the support SM1 as well as filling the folding portion FP.

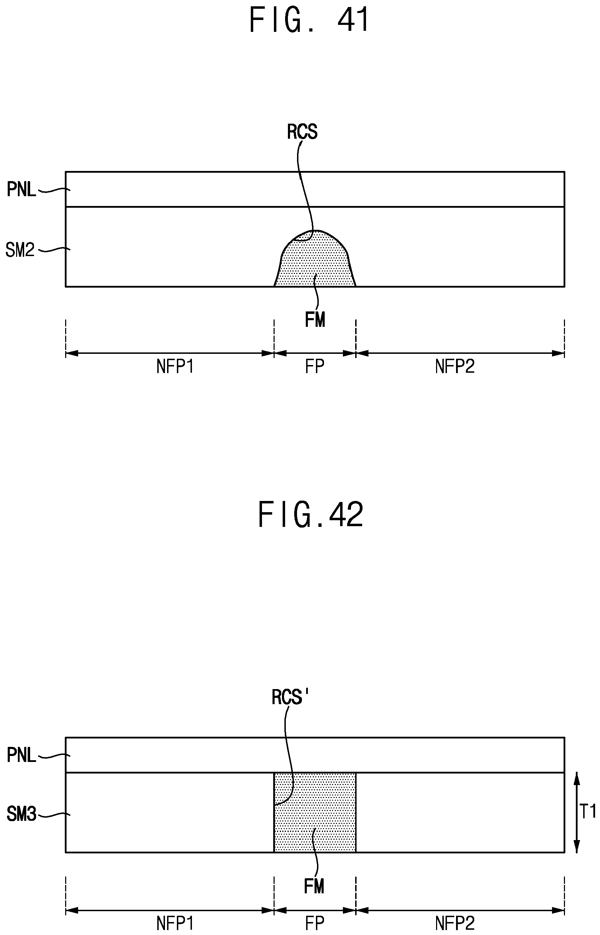

FIGS. 41 and 42 are views illustrating examples of FIG. 37.

For example, a method of manufacturing the display device described with reference to FIG. 41 may be a method of manufacturing the display device of FIG. 14. Also, a method of manufacturing the display device described with reference to FIG. 42 may be a method of manufacturing the display device of FIG. 17.

Each of the manufacturing methods of the display device described with reference to FIGS. 41 and 42 may be substantially same as the manufacturing method of the display device described with reference to FIGS. 33 to 38 except forming the foldable part FP, and filling the filling material FM.

Referring to FIG. 41, a portion overlapping the folding area of the carrier substrate CSUB may be patterned to form the folding portion FP. The recess RCS overlapping the folding area may be formed in the folding portion FP. The recess RCS may have a groove shape. Accordingly, the support SM2 including the folding portion FP, the first non-folding portion NFP1, and the second non-folding portion NFP2 may be formed.

In an embodiment, the carrier substrate CSUB may be etched using a puddle method. A heat source overlapping the folding portion FP may be applied to the carrier substrate CSUB. Accordingly, a temperature gradient due to the heat source may be formed in the carrier substrate CSUB. Accordingly, an etchant is driven toward the folding portion FP, so that the recess RCS having a groove shape may be formed. However, an etching method according to the present invention is not necessarily limited thereto.

In addition, the filling material FM may be further filled in the folding portion FP of the support SM2. For example, the filler FM may fill the recess RCS formed in the folding portion FP. However, the present invention is not necessarily limited thereto, and the filling material FM may be omitted.

Referring to FIG. 42, a portion overlapping the folding area of the carrier substrate CSUB may be patterned to form the folding portion FP. The recess RCS' overlapping the folding area may be formed in the folding portion FP. The recess RCS' may have an opening shape. For example, the recess RCS' may penetrate the carrier substrate. Accordingly, the support SM3 including the folding portion FP, the first non-folding portion NFP1, and the second non-folding portion NFP2 may be formed.

In addition, a filling material FM may be further filled in the folding portion FP of the support SM3. For example, the filling material FM may fill the recess RCS' formed in the folding portion FP. However, the present invention is not necessarily limited thereto, and the filling material FM may be omitted.

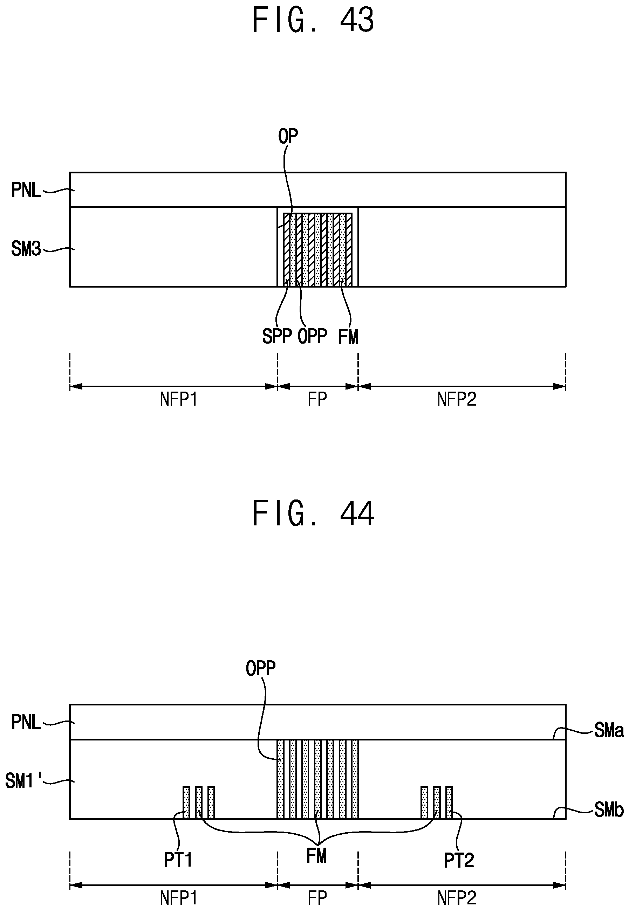

FIG. 43 is a view illustrating an example of FIG. 42.

For example, a method of manufacturing the display device described with reference to FIG. 43 may be a method of manufacturing the display device of FIG. 19.

Referring to FIG. 43, a portion of the carrier substrate CSUB overlapping the folding area FA may be patterned to form the folding portion FP. The recess RCS' overlapping the folding area FA may be formed in the folding portion FP. The recess RCS' may have an opening shape.

The support pattern SPP may be formed on the folding portion FP. The opening pattern OPP may be formed in the support pattern SPP. Also, the support pattern SPP may be formed of stainless steel, carbon fiber, and/or fiberglass.

The support pattern SPP may be disposed in the folding portion FP without an adhesive, and a frame (e.g., the frame FRM of FIG. 21) under the support pattern SPP may support the support pattern SPP (see Fig. 21).

However, the present invention is not necessarily limited thereto, and the support pattern SPP may be attached to the support SM3 or the display panel PNL through an adhesive layer (e.g., the second adhesive layer AL2 of FIG. 22) (see Fig. 22).

FIG. 44 is a view illustrating an example of FIG. 39.

For example, a method of manufacturing the display device described with reference to FIG. 44 may be a method of manufacturing the display device of FIG. 23.

Referring to FIG. 44, a portion overlapping the folding area of the carrier substrate may be patterned to form the folding portion FP. The opening pattern OPP overlapping the folding area may be formed in the folding portion FP.

Also, the first pattern PT1 may be formed on the first non-folding portion NFP1, and the second pattern PT2 may be formed on the second non-folding portion NFP2. Each of the first pattern PT1 and the second pattern PT2 may be formed adjacent to the folding portion FP. Also, the first pattern PT1 and the second pattern PT2 may be formed on the second surface SMb of the support SM1'.

The first pattern PT1 and the second pattern PT2 may be formed simultaneously with the opening pattern OPP. However, the present invention is not necessarily limited thereto.

Meanwhile, respective shapes of the folding part FP, the first pattern PT1 and the second pattern PT2 shown in FIG. 44 are only example, and may be variously changed.

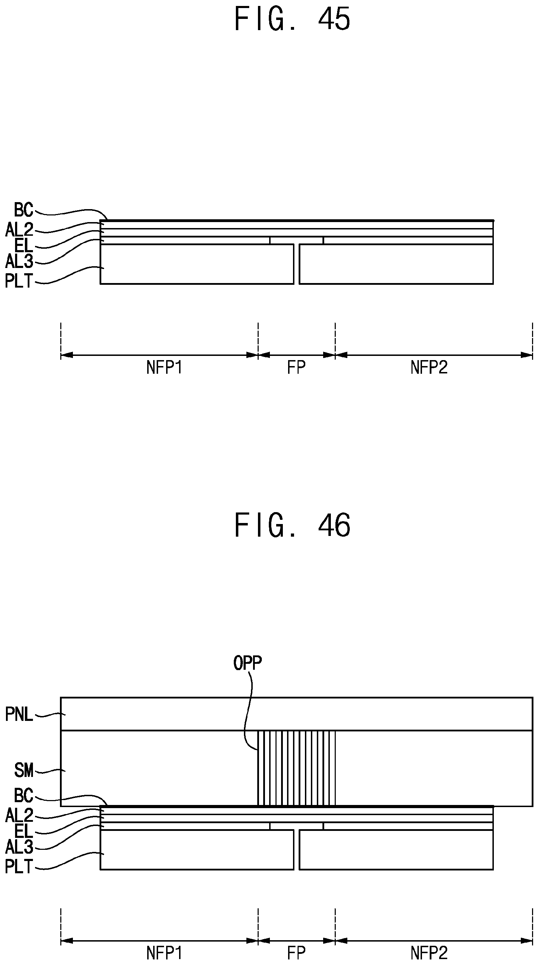

FIGS. 45 and 46 are view illustrating a manufacturing method of a display device according to an embodiment.

For example, a method of manufacturing the display device described with reference to FIGS. 45 and 46 may be a method of manufacturing the display device of FIG. 27.

Referring to FIG. 45, the third adhesive layer AL3 may be formed on the plate PLT. The plate PLT may be attached to the elastic layer EL through the third adhesive layer AL3. The elastic layer EL may be formed on the third adhesive layer AL3, and the second adhesive layer AL2 may be formed on the elastic layer EL.

The black coating layer BC coated with carbon black may be formed on an upper surface of the second adhesive layer AL2. The black coating layer BC may be formed by coating an upper surface of the second adhesive layer AL2 with carbon black. The carbon black may be applied by a physical vapor deposition (PVD) method or a screen printing method.

Further referring to FIG. 46, the second adhesive layer AL2 and the black coating layer BC may be attached to the support SM. For example, the second adhesive layer AL2 and the upper surface of the black coating layer BC may contact the support SM. The elastic layer EL and the plate PLT may be attached to the support SM through the second adhesive layer AL2.

However, the present invention is not necessarily limited thereto, and the second surface SMb of the support SM, which is spaced apart from the display panel PNL, may be coated with carbon black. For example, the black coating layer BC coated with carbon black may be formed between the display panel PNL and the second adhesive layer AL2. Accordingly, the black coating layer BC may reduce the visibility of reflection in the display device 10.

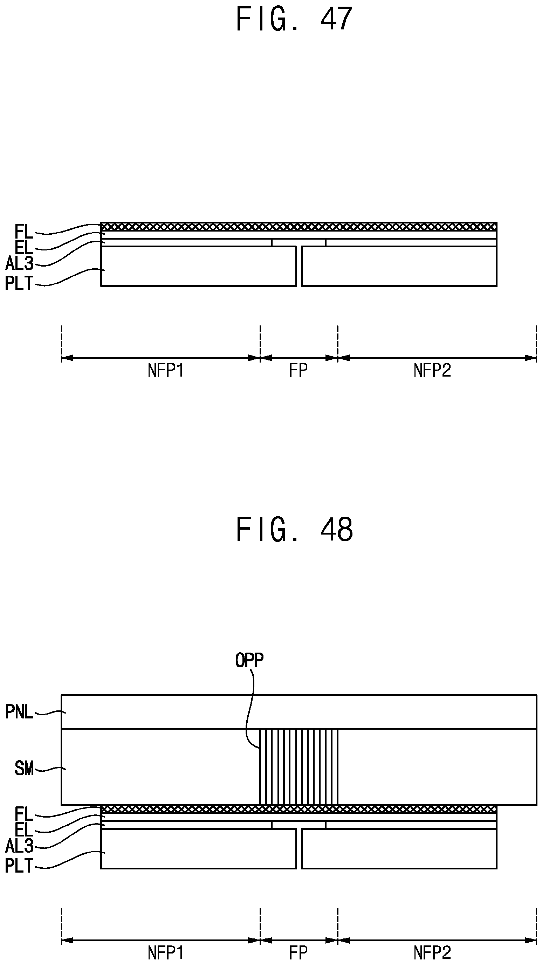

FIGS. 47 and 48 are views illustrating a manufacturing method of a display device according to an embodiment.

For example, a method of manufacturing the display device described with reference to FIGS. 47 and 48 may be a method of manufacturing the display device of FIG. 28.

Referring to FIG. 47, the third adhesive layer AL3 may be formed on the plate PLT. The elastic layer EL may be formed on the third adhesive layer AL3. The functional layer FL may be formed on the elastic layer EL.

The functional layer FL may be formed of a material containing black pigment or a black dye. For example, the functional layer FL may include an adhesive material and may further include a black pigment or a black dye. Accordingly, the functional layer FL may reduce the visibility of reflection of the display device 10.

Further referring to FIG. 48, the functional layer FL may be attached to the support SM. The elastic layer EL and the plate PLT may be attached to the support SM through the functional layer FL.

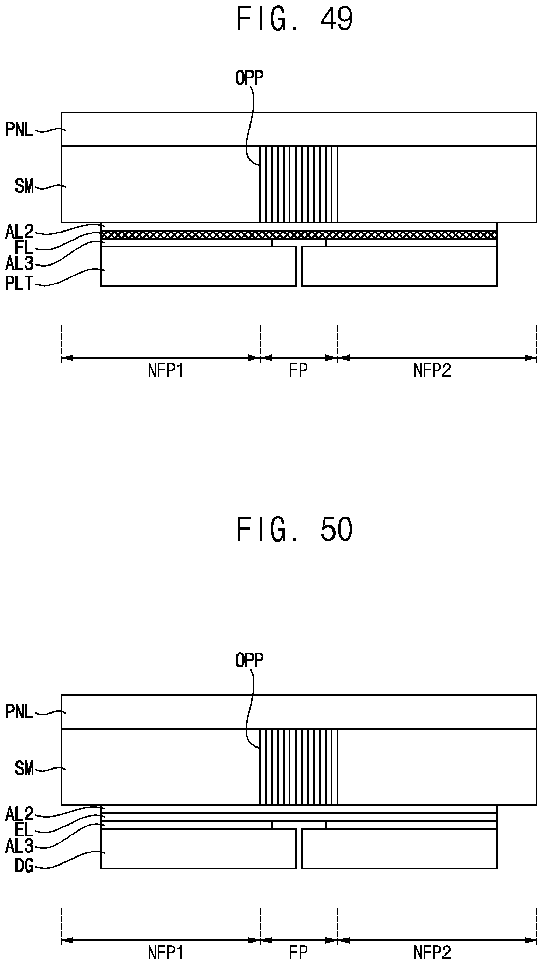

FIG. 49 is a view illustrating an example of FIG. 48.

For example, a method of manufacturing the display device described with reference to FIG. 49 may be a method of manufacturing the display device of FIG. 29.

Referring to FIG. 49, the third adhesive layer AL3 may be formed on the plate PLT. The functional layer FL may be formed on the third adhesive layer AL3. The second adhesive layer AL2 may be formed on the functional layer FL. After that, the second adhesive layer AL2 may be attached to the support SM.

The functional layer FL may be formed of a material containing black pigment or a black dye. For example, the functional layer FL may include polyimide and may further include a black pigment or a black dye. However, the present invention is not necessarily limited thereto, and the functional layer FL may be formed of polyimide and treated with a black primer. Accordingly, the functional layer FL may reduce the visibility of reflection of the display device 10.

FIG. 50 is a view illustrating a manufacturing method of a display device according to an embodiment.

FIG. 50 is a diagram illustrating a manufacturing method of a display device according to an embodiment.

Referring to FIG. 50, the digitizer DG may be formed. The third adhesive layer AL3 may be formed on the digitizer DG, the elastic layer EL may be formed on the third adhesive layer AL3, and the second adhesive layer AL2 may be formed on the elastic layer EL.

The second adhesive layer AL2 may be attached to the support SM. The elastic layer EL and the digitizer DG may be attached to the support SM through the second adhesive layer AL2.

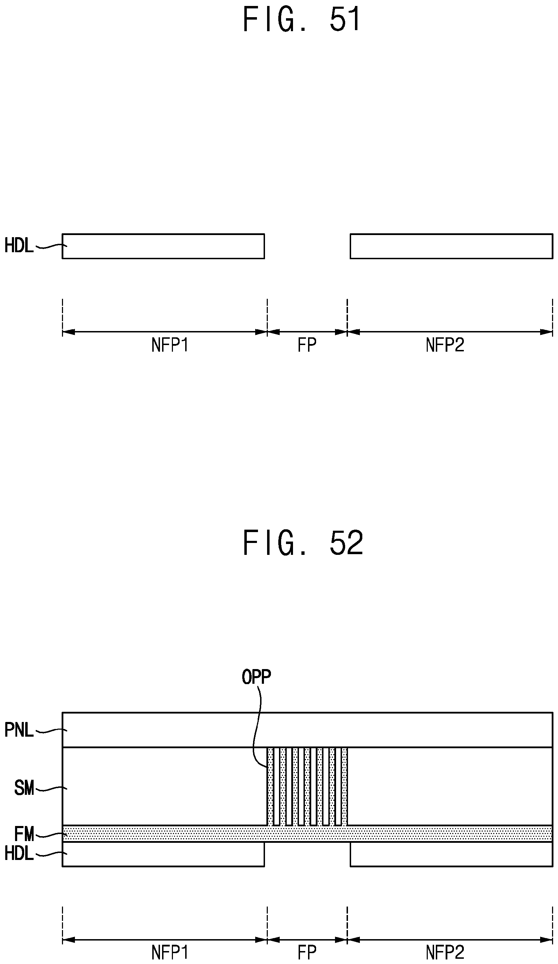

FIGS. 51 and 52 are views illustrating a manufacturing method of a display device according to an embodiment.

For example, a method of manufacturing the display device described with reference to FIGS. 51 and 52 may be a method of manufacturing the display device of FIG. 31.

Referring to FIG. 51, the heat dissipation layer HDL may be formed. The heat dissipation layer HDL may be formed of an alloy. The alloy may include aluminum and/or copper.

Further referring to FIG. 52, the support SM may be disposed on the heat dissipation layer HDL. The filling material FM may be further formed under the support SM. The heat dissipation layer HDL may be attached to the support SM through the filling material FM. However, the present invention is not necessarily limited thereto, and the heat dissipation layer HDL may be attached to the support SM through an adhesive.

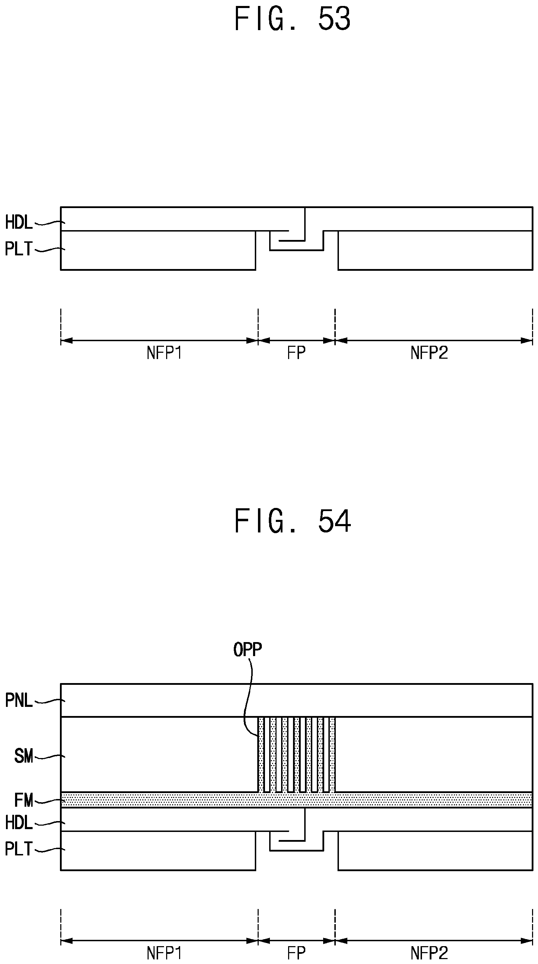

FIGS. 53 and 54 are views illustrating a manufacturing method of a display device according to an embodiment.

For example, a method of manufacturing the display device described with reference to FIGS. 53 and 54 may be a method of manufacturing the display device of FIG. 32.

Referring to FIG. 53, the plate PLT may be formed. The plate PLT may be formed of stainless steel. The heat dissipation layer HDL may be formed on the plate PLT. The heat dissipation layer HDL may be formed of graphite.

Further referring to FIG. 54, the support SM may be disposed on the heat dissipation layer HDL.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the present invention as defined by the appended claims.

It is clear for one of ordinary skill in the art that the disclosed embodiments can be combined where possible.

## Claims

1. A display device (10), comprising:
a display panel (PNL) including a first non-folding area (NFA1), a second non-folding area (NFA2), and a folding area (FA) disposed between the first non-folding area (NFA1) and the second non-folding area (NFA2); and
a support (SM) disposed under the display panel (PNL), and including a first non-folding portion (NFP1) including glass and overlapping the first non-folding area (NFA1), a second non-folding portion (NFP2) including glass and overlapping the second non-folding area (NFA2), and a folding portion (FP), preferably including glass, disposed between the first non-folding portion (NFP1) and the second non-folding portion (NFP2), overlapping the folding area (FA), and including an opening pattern (OPP) or a recess (RCS).

2. The display device (10) of claim 1, wherein the opening pattern (OPP) includes a plurality of openings (HL), each of which has a shape that is rectangular, rhombic, elliptical, wavy, or a rectangle with rounded corners; or wherein the recess (RCS) is an opening or a groove.

3. The display device (10) of claim 1 or 2, further comprising:
a filling material (FM) filling the opening pattern (OPP) or the recess (RCS).

4. The display device (10) of claim 3, wherein the filling material (FM) is further disposed under the first non-folding portion (NFP1) and the second non-folding portion (NFP2).

5. The display device (10) of any one of the preceding claims, further comprising:
a support pattern (SPP), preferably including stainless steel, carbon fiber, and/or fiberglass, disposed in the recess (RCS).

6. The display device (10) of claim 5, further comprising:
an adhesive layer (AL2) disposed under the support pattern (SPP); and
a frame (FRM) disposed under the adhesive layer (AL2) and configured to support the support pattern (SPP).

7. The display device (10) of claim 5, further comprising:
an adhesive layer (AL2), preferably including a pressure sensitive adhesive, PSA, an optically clear resin, OCR, and/or an optically clear adhesive, OCA, disposed on the support pattern (SPP).

8. The display device (10) of any one of the preceding claims, wherein the first non-folding portion (NFP1) includes a first pattern (PT1) adjacent to the folding portion (FP), and
wherein the second non-folding portion (NFP2) includes a second pattern (PT2) adjacent to the folding portion (FP).

9. The display device (10) of claim 8, wherein each of the first pattern (PT1) and the second pattern (PT2) is disposed on one surface of the support (SM) and is spaced apart from the display panel (PNL).

10. The display device (10) of claim 8 or 9, wherein a height (H2) of each of the first pattern (PT1) and the second pattern (PT2) is smaller than a height (H1) of the folding portion (FP), and
wherein a width (W2) of each of the first pattern (PT1) and the second pattern (PT2) is smaller than a width (W1) of the folding portion (FP).

11. The display device (10) of any one of claims 8 to 10, wherein each of the first pattern (PT1) and the second pattern (PT2) includes an opening pattern (OPP) or a recess (RCS).

12. The display device (10) of any one of the preceding claims, further comprising:
a black coating layer (BC) disposed on one surface of the support (SM) and spaced apart from the display panel (PNL).

13. The display device (10) of any one of the preceding claims, further comprising:
a functional layer (FL) disposed under the support (SM) and including a black pigment or a black dye.

14. The display device (10) of any one of the preceding claims, further comprising:
a digitizer (DG) disposed under the support (SM).

15. The display device (10) of any one of the preceding claims, further comprising:
a heat dissipation layer (HDL), preferably including graphite and/or metal, disposed under the support (SM).
